(19) Europäisches Patentamt European Patent Office Office européen des brevets

(11) **EP 3 745 575 B1**

(12) **EUROPEAN PATENT SPECIFICATION**

(45) Date of publication and mention of the grant of the patent:
**08.03.2023 Bulletin 2023/10**

(21) Application number: **20177280.3**

(22) Date of filing: **28.05.2020**

(51) International Patent Classification (IPC):
**H02M 1/42** *(2007.01)*  **H02M 1/12** *(2006.01)*

(52) Cooperative Patent Classification (CPC):
**H02M 1/4208; H02M 1/12; H02M 1/4225;**
H02M 1/0025; Y02B 70/10

(54) **POWER FACTOR CORRECTION CIRCUIT, CONTROL METHOD AND CONTROLLER**

LEISTUNGSFAKTORKORREKTURSCHALTUNG, STEUERVERFAHREN UND STEUERGERÄT

CIRCUIT DE CORRECTION DE FACTEUR DE PUISSANCE, PROCÉDÉ DE COMMANDE ET ORGANE DE COMMANDE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.05.2019 CN 201910471007**

(43) Date of publication of application:
**02.12.2020 Bulletin 2020/49**

(73) Proprietor: **Silergy Semiconductor Technology (Hangzhou) Ltd**
**Zhejiang 310051 (CN)**

(72) Inventors:
• **WANG, Zhaofeng**
  **Zhejiang, 310051 (CN)**
• **HUANG, Xiaodong**
  **Zhejiang, 310051 (CN)**
• **ZHAO, Chen**
  **Zhejiang, 310051 (CN)**

(74) Representative: **Ström & Gulliksson AB**
**P.O. Box 793**
**220 07 Lund (SE)**

(56) References cited:
  WO-A1-2015/099656      US-A1- 2014 028 211
  US-A1- 2018 269 779

• CHIH-WEI CHANG ET AL: "High-PF and ultra-low-THD power factor correction controller by sinusoidal-wave synthesis and optimized THD control", CIRCUITS AND SYSTEMS (ISCAS), 2013 IEEE INTERNATIONAL SYMPOSIUM ON, IEEE, 19 May 2013 (2013-05-19), pages 917-920, XP032446072, DOI: 10.1109/ISCAS.2013.6571997 ISBN: 978-1-4673-5760-9
• LIN HENG-CI ET AL: "A digitally variable on-time controlled PFC flyback converter with primary-side regulation", 2018 7TH INTERNATIONAL SYMPOSIUM ON NEXT GENERATION ELECTRONICS (ISNE), IEEE, 7 May 2018 (2018-05-07), pages 1-4, XP033363536, DOI: 10.1109/ISNE.2018.8394705 [retrieved on 2018-06-22]

**Description**

**FIELD**

The present disclosure relates to power electronic technologies, and in particular to a power factor correction circuit, a control method and a controller.

**BACKGROUND**

Power factor (PF) is the cosine of a phase difference between a voltage and a current, and may also represents a ratio of effective power to apparent power. The power factor is used for characterizing an electrical efficiency of an electrical device. A low power factor represents low power efficiency. By performing power factor correction (PFC), the phase difference between the voltage and the current can be eliminated or decreased, thereby improving the power factor of a system, increasing transmission efficiency of active power, and improving power grid environment.

An active PFC circuit generally relies on fast input current closed-loop adjustment, so that an input current of the PFC can track a sinusoidal alternating current input voltage in real time, thereby achieving power factor correction. Nowadays, A high demand on the power factor correction regarding a total harmonic distortion (THD) has been imposed by the current industries. In addition to requirements on the total harmonic distortion under heavy load conditions, the same requirements as the THD under heavy load conditions are stipulated for the THD under half load conditions and even light load conditions.

In existing solutions for decreasing the total harmonic distortion, factors that affect a total harmonic distortion index is theoretically analyzed, and a corresponding compensation control strategy is proposed based on an established model. However, those solutions are generally applicable to a certain condition.

US2018269779 A1 discloses a power factor correction circuit and a method of controlling a switching-type regulator with power factor correction. The power factor correction circuit includes a power meter configured to measure total harmonic distortion (THD) at an input port; a switching-type regulator that is controllable by a switching control signal in order to adjust a power factor of an input signal thereof; and a controller configured to generate the switching control signal to control the switching-type regulator to perform power factor correction, where the controller minimizes the THD by adjusting a current reference signal according to a measured THD and amplitude ratios of harmonic components.

"High-PF and ultra-low-THD power factor correction controller by sinusoidal-wave synthesis and optimized THD control", CHIH-WEI CHANG ET AL, CIRCUITS AND SYSTEMS (ISCAS), 2013 IEEE INTERNATIONAL SYMPOSIUM ON, IEEE, 19 May 2013 (2013-05-19), pages 917-920, CP032446072, discloses sinusoidal-wave synthesis (SWS) and optimized THD control (OTC) for improving power factor (PF) and total harmonic distortion (THD) over a wide line voltage range. The SWS detects the input line root-mean-square (rms) voltage to generate the digital equivalent code to the OTC for optimizing the THD by tuning the on-time value. The SWS and the OTC provide a feedforward path to reduce the ripple of the feedback voltage for further improving the THD, such that the PFC converter can keep high PF and low THD over a wide line voltage.

LIN HENG-CI ET AL: "A digitally variable on-time controlled PFC flyback converter with primary-side regulation", 2018 7TH INTERNATIONAL SYMPOSIUM ON NEXT GENERATION ELECTRONICS (ISNE), IEEE, 7 May 2018 (2018-05-07) discloses a controller for a power factor correction circuit operated in critical conduction mode. The on-time is corrected such that the average current during a switching cycle equals the shape of the sinusoidal input voltage, which results in lower THD.

**SUMMARY**

In view of the above, a power factor correction circuit, a control method, and a controller configured to perform the control method are provided according to the present disclosure, so as to decrease the total harmonic distortion of the power factor correction circuit with a universal method.

According to a first aspect of the present disclosure, a power factor correction circuit is as specified in claim 1.

Preferably, a midpoint of the phase range where the phase of each of the harmonic components is located is determined as a reference point, and whether a phase adjustment direction is a phase increasing direction or a phase decreasing direction is determined, and the phase of each of the predetermined harmonic components is adjusted based on the determined phase adjustment direction from the reference point until the measured THD is no longer decreased.

Preferably, the controller is configured to perform either a) sampling an input voltage of the switching-type regulator to obtain an input voltage sampling signal, and adjusting the on-time of the main switch of the switching-type regulator based on the control signal, wherein the control signal is a quotient of a first signal divided by the input voltage sampling signal, the first signal a product signal of an amplitude of a fundamental component and a sum of at least one voltage harmonic component corresponding to the at least one predetermined harmonic component, each voltage harmonic component has the same amplitude ratio with a corresponding harmonic component in the input signal and has an opposite phase to the corresponding harmonic component, and the predetermined harmonic component is acquired based on the input voltage sampling signal; or b) sampling an input voltage of the switching-type regulator to obtain an input voltage sampling signal, and adjusting the on-time of the main switch of the switching-type regulator based on the control signal, wherein the control signal is one plus a quotient of a second signal divided by the input voltage sampling signal, the second signal is a product signal of an amplitude of a fundamental component and a sum of at least one voltage harmonic component corresponding to the at least one predetermined harmonic component, each voltage harmonic component has the same amplitude ratio with a corresponding harmonic component in the input signal and has an opposite phase to the corresponding harmonic component, and the predetermined harmonic component is acquired based on the input voltage sampling signal.

Preferably, the controller is configured to perform either a) adjusting the on-time of the main switch of the switching-type regulator based on the control signal, wherein the control signal is a quotient of a third signal divided by a fundamental component, the third signal is a sum of at least one voltage harmonic component corresponding to the at least one predetermined harmonic component, each voltage harmonic component has the same amplitude ratio with a corresponding harmonic component in the input signal and has an opposite phase to the corresponding harmonic component, and the predetermined harmonic component is acquired by performing voltage zero-crossing detection on an input voltage; or b) adjusting the on-time of the main switch of the switching-type regulator based on the control signal, wherein the control signal is one plus a quotient of a fourth signal divided by a fundamental component, the fourth signal is a sum of at least one voltage harmonic component corresponding to the at least one predetermined harmonic component, each voltage harmonic component has the same amplitude ratio with a corresponding harmonic component in the input signal and has an opposite phase to the corresponding harmonic component, and the predetermined harmonic component is acquired by performing voltage zero-crossing detection on the input voltage.

Preferably, the voltage harmonic component is obtained by acquiring a product signal of each predetermined harmonic component and the amplitude ratio corresponding to the predetermined harmonic component and then performing a phase adjustment on the product signal.

Preferably, the voltage harmonic component is a product signal of the predetermined harmonic component and the amplitude ratio corresponding to the predetermined harmonic component.

Preferably, the controller is configured to use k times a product of the control signal and a compensation signal for characterizing the on-time of the main switch of the switching-type regulator, and the compensation signal is a difference between a voltage reference signal and an output voltage.

Preferably, each of the at least one predetermined harmonic component is adjacent to a fundamental component.

In a second aspect, a control method for controlling a switching-type regulator to perform power factor correction is provided. The control method includes measuring a total harmonic distortion (THD); adjusting, by a controller, a on-time of a main switch of the switching-type regulator based on measured total harmonic distortion to decrease the THD.

Preferably, the control method according includes superimposing inversely at least one predetermined harmonic component on a control signal for controlling the on-time of the main switch of the switching-type regulator to adjust the on-time, to decrease the THD.

Preferably, adjusting the on-time of the main switch of the switching-type regulator based on the measured total harmonic distortion includes adjusting an amplitude ratio of the predetermined harmonic component based on the measured total harmonic distortion to adjust the on-time of the main switch of the switching-type regulator, to decrease the THD.

Preferably, the control method includes at least one of sampling an input voltage of the switching-type regulator to obtain an input voltage sampling signal, and adjusting the on-time of the main switch of the switching-type regulator based on the control signal, wherein the control signal is a quotient of a first signal divided by the input voltage sampling signal, the first signal is a sum of the input voltage sampling signal and a second signal, the second signal is a product of an amplitude of a fundamental component and a value of a voltage harmonic component corresponding to the predetermined harmonic component superimposed inversely, each voltage harmonic component has the same amplitude ratio with a corresponding harmonic component in the input signal, and the predetermined harmonic component acquired based on the input voltage sampling signal; and sampling an input voltage of the switching-type regulator to obtain an input voltage sampling signal, and adjusting the on-time of the main switch of the switching-type regulator based on the control signal, wherein the control signal is one plus a quotient of a second signal divided by the input voltage sampling signal, the second signal is a product of an amplitude of a fundamental component and a value of the voltage harmonic component corresponding to the predetermined harmonic component superimposed inversely, each voltage harmonic component has the same amplitude ratio with a corresponding harmonic component in the input signal, and the predetermined harmonic component acquired based on the input voltage sampling signal.

Preferably, the control method includes at least one of adjusting the on-time of the main switch of the switching-type regulator based on the control signal, wherein the control signal is a quotient of a third signal divided by a fundamental component, the third signal is obtained by inversely superimpose at least one voltage harmonic component corresponding to the at least one predetermined harmonic component on the fundamental component, each voltage harmonic component has the same amplitude ratio with a corresponding harmonic component in the input signal, and the predetermined harmonic component acquired by performing voltage zero-crossing detection on an input voltage; and adjusting the on-time of the main switch of the switching-type regulator based on the control signal, wherein the control signal is one plus a quotient of a fourth signal divided by a fundamental component, the fourth signal is obtained by inversely superimpose at least one voltage harmonic component corresponding to the at least one predetermined harmonic component, each voltage harmonic component has the same amplitude ratio with a corresponding harmonic component in the input signal, and the predetermined harmonic component acquired by performing voltage zero-crossing detection on an input voltage.

Preferably, the control method includes measuring an amplitude ratio (Hn) of each harmonic component at the input port; and setting the amplitude ratio of each of the at least one predetermined harmonic component based on a measured amplitude ratio of a corresponding harmonic component, and adjust a phase of each of the at least one predetermined harmonic component based on the measured total harmonic distortion to adjust the on-time of the main switch of the switching-type regulator, to decrease the THD.

Preferably, the control method includes setting, based on the measured amplitude ratio of a corresponding harmonic component, the amplitude ratio of one of the at least one predetermined harmonic component, and adjusting the phase of the one of the at least one predetermined harmonic component in a predetermined order until the measured THD is no longer decreased.

Preferably, the control method includes at least one of sampling an input voltage of the switching-type regulator to obtain an input voltage sampling signal, and adjusting the on-time of the main switch of the switching-type regulator based on the control signal, wherein the control signal is a quotient of a first signal divided by the input voltage sampling signal, the first signal is a sum of the input voltage sampling signal and a second signal, the second signal is a product of an amplitude of a fundamental component and a sum of at least one voltage harmonic component corresponding to the at least one predetermined harmonic component, each voltage harmonic component has the same amplitude ratio with a corresponding harmonic component in the input signal and has an opposite phase to the corresponding harmonic component, and the predetermined harmonic component acquired based on the input voltage sampling signal and sampling an input voltage of the switching-type regulator to obtain an input voltage sampling signal, and adjusting the on-time of the main switch of the switching-type regulator based on the control signal, wherein the control signal is one plus a quotient of a second signal divided by the input voltage sampling signal, the second signal is a product of an amplitude of a fundamental component and a sum of at least one voltage harmonic component corresponding to the at least one predetermined harmonic component, each voltage harmonic component has the same amplitude ratio with a corresponding harmonic component in the input signal and has an opposite phase to the corresponding harmonic component, and the predetermined harmonic component acquired based on the input voltage sampling signal.

Preferably, the control method includes at least one of adjusting the on-time of the main switch of the switching-type regulator based on the control signal, wherein the control signal is a quotient of a third signal divided by a fundamental component, the third signal is a sum of the fundamental component and at least one voltage harmonic component corresponding to the at least one predetermined harmonic component, each voltage harmonic component has the same amplitude ratio with a corresponding harmonic component in the input signal and has an opposite phase to the corresponding harmonic component, and the predetermined harmonic component acquired by performing voltage zero-crossing detection on an input voltage; and adjusting the on-time of the main switch of the switching-type regulator based on the control signal, wherein the control signal is one plus a quotient of a fourth signal divided by a fundamental component, the fourth signal is a sum of at least one voltage harmonic component corresponding to the at least one predetermined harmonic component, each voltage harmonic component has the same amplitude ratio with a corresponding harmonic component in the input signal and has an opposite phase to the corresponding harmonic component, and the predetermined harmonic component acquired by performing voltage zero-crossing detection on the input voltage.

In a third aspect, a controller is provided. The controller includes a memory, configured to receive a total harmonic distortion (THD) generated by a power meter; and a processor, configured to generate a switch control signal to control a switching-type regulator to perform power factor correction, where the controller adjusts an on-time of a main switch of the switching-type regulator based on the measured THD to decrease the THD.

In technical solutions of the present disclosure, the on-time of the main switch of the switching-type regulator is adjusted based on the measured total harmonic distortion to decrease the total harmonic distortion while performing power factor correction, thereby effectively decreasing the total harmonic distortion without special compensation for a certain type of factors that affect the total harmonic distortion index, such that the overall control method is simplified.

## BRIEF DESCRIPTION OF THE DRAWINGS

The above and other objects, features and advantages of the present disclosure are clearer through the following description of embodiments of the present disclosure with reference to the accompanying drawings. In the drawings:

FIG. 1 is a schematic diagram of an example power factor correction circuit according to the present disclosure;

FIG. 2 is a schematic diagram of an example power stage circuit of an example power factor correction circuit according to an embodiment of the present disclosure;

FIG. 3 is a flowchart of a control method according to the present disclosure;

FIG. 4 is a flowchart of a control method for adjusting amplitude ratios of harmonic components according to the present disclosure;

FIG. 5 is a diagram showing a data flow of a controller according to the conventional technology;

FIG. 6 is a diagram showing a data flow of the controller adjusting amplitude ratios of harmonic components according to a first comparative example of the present disclosure;

FIG. 7 is a diagram showing a data flow of the controller adjusting amplitude ratios of harmonic components according to a second comparative example of the present disclosure;

FIG. 8 is a flowchart of a control method according to the present invention;

FIG. 9 is a flowchart of a first method for adjusting phases of harmonic components according to the present invention;

FIG. 10 is a flowchart of a second method for adjusting phases of harmonic components according to the present invention;

FIG. 11 is a schematic diagram showing a data flow of the controller adjusting phases of harmonic components according a first embodiment of the present invention;

FIG. 12 is a schematic diagram showing a data flow of the controller adjusting phases of harmonic components according to a second embodiment of the present invention;

FIG. 13 is an operation waveform diagram of an example power factor correction circuit according to the present disclosure; and

FIG. 14 is an operation waveform diagram of another example power factor correction circuit according to the present disclosure.

## DETAILED DESCRIPTION OF EMBODIMENTS

The present disclosure is described below based on examples and embodiments. However, the present disclosure is not limited to these examples and embodiments. In the following detailed description of the present disclosure, some specific details are described in detail. Those skilled in the art can fully understand the present disclosure without the description of these details. In order to avoid obscuring the essence of the present disclosure, well-known methods, processes, procedures, elements and circuits are not described in detail.

In addition, those skilled in the art should understand that the drawings provided herein are for illustrative purposes, and are not necessarily drawn to scale.

Further, it should be understood that in the following description, "circuit" refers to a conductive loop formed by at least one element or sub-circuit through electrical or electromagnetic connection. In a case that an element or a circuit is "connected" to another element or an element/circuit is "connected" between two nodes, the element or circuit may be directly coupled or connected to another element or coupled or connected to another element via an intermediate element. Connections among elements may be physical, logical, or a combination thereof. In contrast, in a case that an element is "directly coupled" or "directly connected" to another element, there is no intermediate element therebetween.

Unless the context clearly requires otherwise, words "including", "comprising" and the like in the specification and claims should be interpreted as inclusive rather than exclusive or exhaustive, that is, "including but not limited to".

In the description of the present disclosure, it should be understood that terms "first", "second" and the like are for descriptive purposes only, and cannot be understood as indicating or implying relative importance. In addition, in the description of the present disclosure, unless otherwise stated, "multiple" means two or more.

Harmonic distortion indicates that an output signal includes additional harmonic components compared with an input signal, resulting from a nonlinear element in a system. Total harmonic distortion (THD) is defined as a square root of a square sum of a ratio of an effective value $G_n$ of each harmonic component to an effective value $G_1$ of a fundamental component within a certain order H, that is:

$$THD = \sqrt{\sum_{n=2}^{H} \left(\frac{G_n}{G_1}\right)^2}.$$

In a case that total harmonic distortion (THD) of a device is too high, wave distortion may be caused to a voltage and a current in a power network, to affect a normal operation of other devices in the power network. A nonlinear element in an active power factor correction (PFC) circuit causes high-order harmonic components in an input current. In order to avoid the influence of high-order harmonic components in the power network, it is required to reduce the total harmonic distortion (THD).

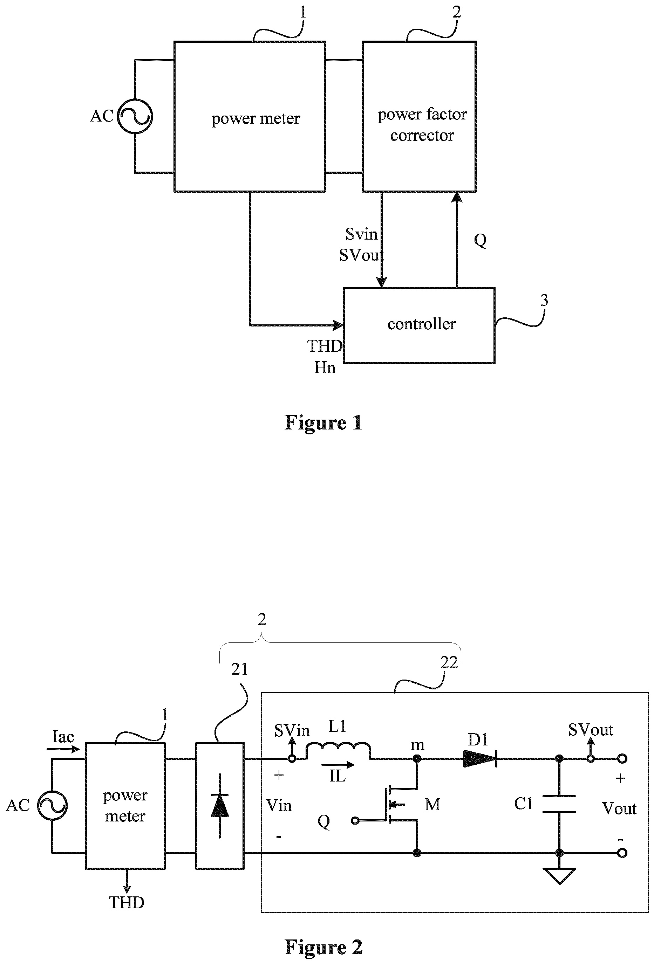

FIG. 1 is a schematic diagram of an example power factor correction circuit according to the present disclosure. As shown in FIG. 1, the power factor correction circuit in this embodiment includes power meter 1, power factor corrector 2, and controller 3. Power meter 1 and power factor corrector 2 form a power stage circuit of the power factor correction circuit.

FIG. 2 is a schematic diagram of an example power stage circuit of an example power factor correction circuit according to an embodiment of the present disclosure. As shown in FIG. 2, power factor corrector 2 may include rectifier circuit 21 and switching-type regulator 22. Rectifier circuit 21 is configured to convert an alternating current Iac inputted from an input source AC into a direct current. Rectifier circuit 21 can be implemented by various conventional rectifier circuits, such as a half bridge rectifier circuit or a full bridge rectifier circuit. Switching-type regulator 22 is configured to perform power factor correction under control of a switch control signal Q. In FIG. 2, a switching-type regulator 22 having a boost topology (BOOST) is taken as an example for description. It should be understood by those skilled in the art that the switching-type regulator 22 may have other topologies, including but not limited to a buck topology (BUCK), a buck-boost topology (BUCK-BOOST), a flyback topology (FLYBACK) and the like. In FIG. 2, switching-type regulator 22 includes inductor L1 for storing energy, switch M, diode D1, and capacitor C1. Inductor L1 is connected between an input port and an middle terminal m. Switch M is connected between middle terminal m and a ground terminal. Diode D1 is connected between the middle terminal m and an output terminal and is configured to rectify an inductor current. Capacitor C1 is connected between the output terminal and the ground terminal, and is configured to filter an output voltage. Switch M is turned on or off under the control of switch control signal Q, thereby controlling inductor current, so as to correct a power factor actively.

In the embodiments, the on-time of the main switch of switching-type regulator 22 is adjusted. Specifically, At least one predetermined harmonic component is inversely superimposed in the input current of switching-type regulator 22, thus compensating the harmonic component in the input current and minimizing the THD. Specifically, at least one predetermined harmonic component is inversely superimposed on a control signal for adjusting the on-time of the main switch of switching-type regulator 22, to decrease the THD.

As shown in FIG. 1, the power stage circuits further include multiple sampling circuits, to sample input voltage Vin and output voltage Vout of switching-type regulator 22, and output an input voltage sampling signal SVin and output voltage sampling signal SVout. Under some circumstances, only output voltage Vout is sampled outputting output voltage sampling signal SVout for convenience. The above input voltage sampling signal SVin and output voltage sampling signal SVout are fed back to controller 3 or output voltage sampling signal SVout is fed back to the controller 3, for generating switch control signal Q. Specifically, switch control signal Q characterizes the on-time and off-time of the main switch of switching-type regulator 22. Further, power meter 1 is connected to an input port of power factor corrector 2 for measuring the THD of a signal at the input port. Moreover, the measured THD is also fed back to controller 3 for generating switching control signal Q. In some embodiments, power meter 1 measures an amplitude ratio Hn of the harmonic component of the signal at the input port and the measured amplitude ratio Hn of the harmonic component is also fed back to controller 3, for generating switch control signal Q.

Controller 3 is configured to generate switch control signal Q based on input voltage sampling signal SVin and output voltage sampling signal SVout (only output voltage sampling signal SVout in some embodiments) as well as the measured total harmonic distortion THD (including the amplitude ratio Hn of each harmonic component in some embodiments), to control sinusoidal signal switching-type regulator 22. Controller 3 adjusts the on-time of the main switch of the switching-type regulator 22 based on the measured THD (including amplitude ratio Hn of each harmonic component in some embodiments) to decrease the THD while performing power factor correction. In an embodiment, controller 3 performs a control strategy in a digital manner to generate switch control signal Q. That is, controller 3 leads the measured total harmonic distortion THD into a control loop, to generate switch control signal Q in a closed-loop control manner for minimizing the THD. Therefore, the on-time of the main switch of the switching-type regulator 22 is adjusted based on the measured THD, to realize the harmonic compensating for each harmonic component in the input signals, so as to decrease THD while performing power factor correction. Therefore, the THD can be reduced without performing compensation design specifically for a category of factors affecting THD indicators, thereby simplifying the control method.

As described above, harmonic distortion indicates that the output signal includes additional harmonic components compared with the input signal due to a nonlinear element in a system. Since an alternating current inputted to a power stage circuit of a power factor correction circuit is a periodic signal. The periodic signal can be analyzed as a superposition of a direct-current signal and sinusoidal signals with different frequencies by the Fourier analysis. Here, each harmonic component is a sinusoidal signal and the frequency of the harmonic component is multiple times that of the sinusoidal signal. Therefore, at least one predetermined harmonic component with the same effective value and an opposite phase compared with each harmonic component of the periodic signal can be superimposed (that is, opposite superposition) on the periodic signal to counteract each harmonic component, thereby reducing the THD. Further, the input current of switching-type regulator 22 is substantially identical to the inputted alternating current signal, that is, Iin = Iac. Therefore, the predetermined harmonic component is inversely superimposed on input current Iin of switching-type regulator 22 by adjusting the on-time of the main switch of switching-type regulator 22 such that the unnecessary harmonic component is counteracted and the adjustment of input current Iin is realized. Further, the THD is decreased or decreased.

In some cases, even harmonic components (e.g., a second harmonic component, a fourth harmonic component and the like) may be counteracted during rectification due to symmetrical phases. Therefore, it is only required to perform opposite superimposition on odd harmonic components, to greatly reduce the total harmonic distortion. However, it should be understood that opposite superimposition may be performed on both the even harmonic components and the odd harmonic components, to reduce the THD more accurately, however, this may cause an increased computational complexity.

In the embodiment, the predetermined harmonic components are set by a system designer. For example, controller 3 can be configured to compensate only on a third harmonic component of the input signal. In a case that the input signal also includes a fifth harmonic component or a seventh harmonic component, compensation may be not performed on the fifth harmonic component and the seventh harmonic component of the input signal. In that case, the system has a low complexity and a fast reaction speed. For example, controller 3 may further be configured to perform compensation on a third harmonic component, a fifth harmonic component, a seventh harmonic component, a ninth harmonic component of the input signal and etc. In a case that the input signal only includes a fifth harmonic component and a seventh harmonic component, based on amplitude ratio Hn of each harmonic component of the input signal measured by power meter 1, amplitude ratios of a predetermined third harmonic component and a ninth harmonic component are set to be zero. Thus, multiple harmonic components of the input signal can be performed compensation.

In a case that the input current of the power factor correction circuit includes only the fundamental component, the input current *Iin* of the power factor correction circuit only including the fundamental component may be expressed as:

$$I_{in} = \frac{V_{in} * T_{on}}{2L} = \frac{V_m * \sin(\omega t) * T_{on}}{2L}$$

Here, *Vm, L* and *Ton* represent an amplitude ratio of the fundamental component, an inductance parameter, and the on-time of the main switch of the switching-type regulator 22 in a constant on-time mode respectively.

However, due to the non-linear element in the circuit, the input current of the power factor correction circuit further includes harmonic components in addition to the fundamental component. Therefore, the harmonic component having a phase opposite to that of the harmonic component in the input current may be superimposed on the input current. When sampling the input voltage, input current $Iin_{new1}$ satisfies the following formula after performing a THD compensation.

$$I_{in_{new1}} = \frac{V_{in} + V_m * (A\sin(3\omega t) + B\sin(5\omega t) + C\sin(7\omega t) + D\sin(9\omega t) + ...)\, {}^*T_{on}}{2L}$$

$$= \frac{V_{in} * (V_{in} + V_m * (A\sin(3\omega t) + B\sin(5\omega t) + C\sin(7\omega t) + D\sin(9\omega t) + ...))}{2L * V_{in}} * T_{on}$$

$$= \frac{V_{in} * T_{on}}{2L} * \frac{V_{in} + V_m * (A\sin(3\omega t) + B\sin(5\omega t) + C\sin(7\omega t) + D\sin(9\omega t) + ...)}{V_{in}}$$

In the formula above, A, B, C, and D are ratios of amplitudes of harmonic component to amplitudes of the fundamental component (i.e., amplitude ratios). Moreover, the constant above varies from -1 to 1 and on-time $T_{on-new1}$ of the main switch of the switching-type regulator 22 after performing a THD compensation is:

$$T_{on\_new1} = T_{on} * \frac{V_{in} + V_m * (A\sin(3\omega t) + B\sin(5\omega t) + C\sin(7\omega t) + D\sin(9\omega t) + ...)}{V_{in}}$$

When the input voltage is not sampled, and the input voltage is an ideally sinusoidal voltage, that is, the input voltage is *Vm\*sin(wt)*, input current $Iin_{new2}$ satisfed the following formula after performing a THD compensation.

$$I_{in_{new}} = \frac{V_m * (\sin(\omega t) + A\sin(3\omega t) + B\sin(5\omega t) + C\sin(7\omega t) + D\sin(9\omega t) + ...) * T_{on}}{2L}$$

$$= \frac{V_m * \sin(\omega t) * T_{on}}{2L} * \frac{\sin(\omega t) + A\sin(3\omega t) + B\sin(5\omega t) + C\sin(7\omega t) + D\sin(9\omega t) + ...}{\sin(\omega t)}$$

$$= \frac{V_{in} * T_{on}}{2L} * \frac{\sin(\omega t) + A\sin(3\omega t) + B\sin(5\omega t) + C\sin(7\omega t) + D\sin(9\omega t) + ...}{\sin(\omega t)}$$

In the formula above, A, B, C, and D are ratios of amplitudes of harmonic component to amplitudes of the fundamental component (i.e., amplitude ratios). Moreover, the constant above varies from -1 to 1 and on-time $T_{on-new2}$ of the main switch of the switching-type regulator 22 after performing a THD compensation is:

$$T_{on\_new2} = T_{on} * \frac{\sin(\omega t) + A\sin(3\omega t) + B\sin(5\omega t) + C\sin(7\omega t) + D\sin(9\omega t) + ...}{\sin(\omega t)}$$

According to the formulas above, based on the constant on-time mode (i.e., the on-time of the main switch of the switching-type regulator 22 remains the same in a steady state), at least one predetermined harmonic component is inversely superimposed on a control signal for controlling the on-time of the main switch of switching-type regulator 22 to adjust the on-time. Thus, at least one predetermined harmonic component is inversely superimposed on input current Iin of switching-type regulator 22. In such case, the unnecessary harmonic components in input current Iin of switching-type regulator 22 can be counteracted by performing the compensation on the harmonic component in the the inputted alternating current. Therefore, the THD is decreased or decreased.

Based on $T_{on-new1}$ and $T_{on-new2}$ mentioned above, the amplitude ratio of each harmonic component in the inputted alternating current is required to be determined to adjust the on-time of the main switch. Therefore, the measured THD is led into the control loop to determine the amplitude ratio of each harmonic component. In an embodiment, controller 3 is configured to adjust the amplitude ratio of each harmonic component based on the measured THD to decrease the THD. In an embodiment, a phase of each harmonic component is considered as identical to that of the fundamental component. However, in some cases, the phase of each harmonic component is greatly different from that of the fundamental component. Therefore, in addition to determining the amplitude ratio of each harmonic component, the phase of each harmonic component is also required to be determined. Therefore, the measured amplitude ratio Hn of each harmonic component and the THD are introduced to the control loop to assist in determining the phase of each harmonic component. In an embodiment, controller 3 is configured to adjust the phase of each harmonic component based on the measured THD and the amplitude ratio of the harmonic component, to decrease the THD. In a word, two methods for adjusting the on-time of the main switch of the switching-type regulator 22 are provided according to the present disclosure. In one method, the amplitude ratio of each harmonic component is adjusted based on the measured THD to decrease the THD. In the other method, the phase of each harmonic component is adjusted based on the measured THD and the amplitude ratio Hn of each harmonic component, to decrease THD.

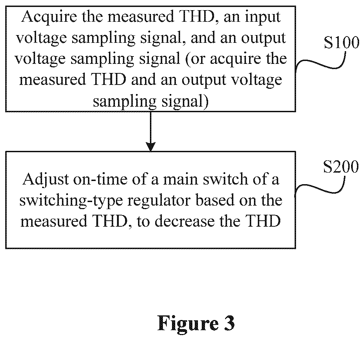

FIG. 3 is a flowchart of a control method according to the present disclosure. In the control method, the amplitude ratio of each harmonic component is adjusted based on the measured THD to decrease the THD. As shown in FIG. 3, specifically, the control method includes the following steps S100 to S200.

In step S100, the measured total harmonic distortion THD, input voltage sampling signal SVin, and output voltage sampling signal SVout are acquired. Optionally, only the measured total harmonic distortion THD and output voltage sampling signal SVout are acquired.

In step S200, the on-time of the main switch of the switching-type regulator is adjusted based on the total harmonic distortion THD, to decrease the total harmonic distortion THD.

Further, in step S200, power factor correction is also performed based on input voltage sampling signal SVin and output voltage sampling signal SVout or based on output voltage sampling signal SVout in other control loops.

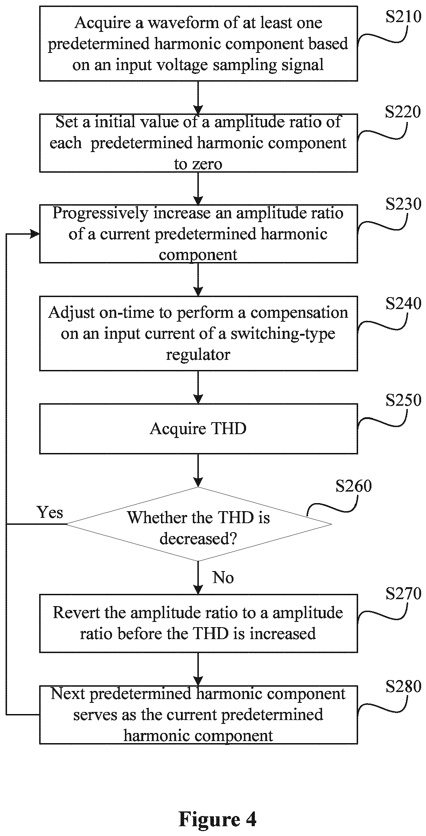

Specifically, the total harmonic distortion THD may be decreased by performing the following steps S210 to S280 shown in FIG. 4.

In step S210, at least one predetermined harmonic component is acquired based on the input voltage sampling signal.

Since there may be multiple harmonic components in an input voltage, compensation is generally performed on only one or more harmonic components with a frequency close to a fundamental frequency. The at least one predetermined harmonic components are ranked in advance respectively, and an amplitude ratio of each predetermined harmonic component is set in order.

In step S220, initial values of amplitude ratios of the one or more each predetermined harmonic component are set to be zero.

In step S230, the amplitude ratio of the predetermined harmonic component is progressively increased. In such case, the amplitude ratio of the predetermined harmonic component may be increased with a predetermined step length, or with a changed increased amplitude, which is calculated for every operation.

In step S240, the on-time is adjusted to perform a compensation on the input current of the switching-type regulator.

Specifically, a predetermined harmonic component is acquired. Then, the predetermined harmonic component is multiplied by an amplitude ratio corresponding to the predetermined harmonic component to obtain a multiplied signal, and the multiplied signal is superimposed on the control signal of the on-time of the main switch of the switching-type regulator.

In step S250, after adjusting the on-time, new THD is measured and acquired.

In step S260, it is determined whether the THD is decreased after the on-time is adjusted. If the THD is decreased, the process proceeds to step S230, to progressively increase the amplitude ratio of the predetermined harmonic component. If the THD is not decreased, it is indicated that the amplitude ratio of the predetermined harmonic component before being increased approaches actual amplitude ratio of the current harmonic component the most. Then the process proceeds to step S270.

In step S270, the amplitude ratio of the current predetermined harmonic component is reverted to the amplitude ratio before the THD increases.

In addition, the predetermined harmonic component having the amplitude ratio before the THD is increased is inversely superimposed on the control signal of the on-time of the main switch.

In step S280, a next predetermined harmonic component serves as the current predetermined harmonic component. The control method returns to step S230 to adjust the amplitude ratio of the next harmonic component.

As described above, the amplitude ratio of each predetermined harmonic component which approaches the actual the amplitude ratio most is obtained in a one-by-one manner. Thus, the THD of the system is reduced during the whole operation. It is to be noted that, the adjusting of the amplitude ratio of each predetermined harmonic component is maintained during operation of a system, such that the THD of the system is reduced during the whole operation.

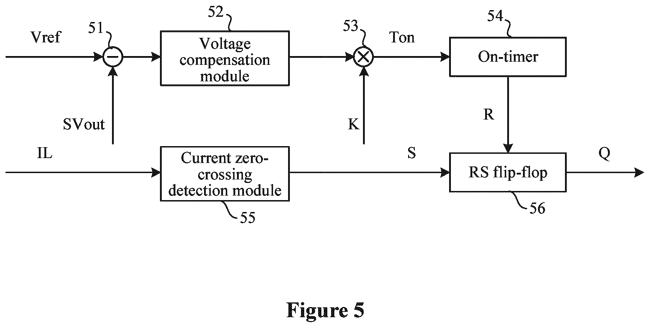

FIG. 5 is a diagram showing a data flow of a controller according to the conventional technology. As shown in FIG. 5, the controller controls the on-time of the main switch of the switching-type regulator in a closed-loop control manner. In the conventional technology, a control mode is a constant on-time mode. That is, in a steady state, the on-time Ton is constant. subtractor 51 is used to acquire a difference between output voltage sampling signal SVout and voltage reference signal Vref, and then voltage compensation module 52 outputs compensation signal Vcmp. Compensation signal Vcmp is multiplied by a proportionality coefficient K by multiplier 53. The product signal outputted from multiplier 53 characterizes the on-time Ton of the main switch, controlling on-timer 54 to time. After on-timer 54 finishes the timing, RS flip-flop 56 is reset. Current zero-crossing detection module 55 performs zero-crossing detection on the inductor current. When it is detected that the inductor current crosses zero, RS flip-flop 56 is set. Then RS flip-flop 56 outputs switch control signal Q. A controller in conventional technology lacks of a universal mechanism to compensate a THD of a circuit.

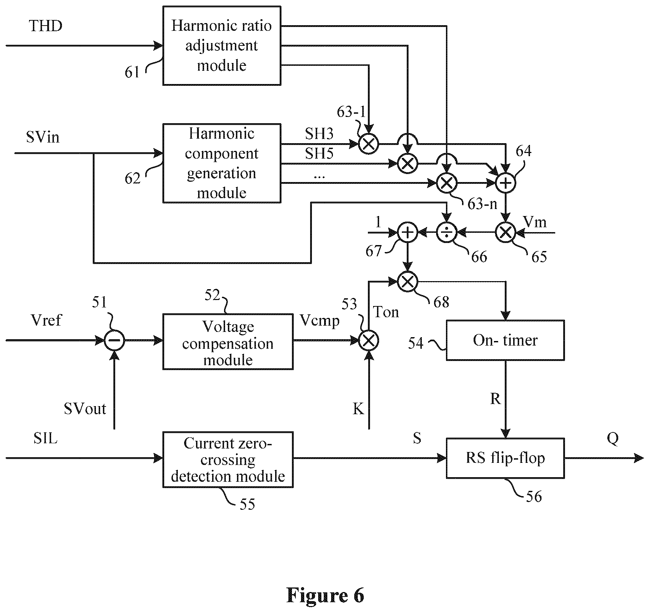

FIG. 6 is a diagram showing a data flow of the controller adjusting amplitude ratios of harmonic components according to a first comparative example of the present disclosure. In the first comparative example, the input voltage signal is required to be sampled, at least one predetermined harmonic component is inversely superimposed on the control signal for controlling the on-time of the main switch of the switching-type regulator. That is, the on-time is adjusted by As shown in FIG. 6, based on the control method in FIG. 5, the on-time Ton in the constant on-time mode is further adjusted to decrease the THD. In addition to subtractor 51, voltage compensation module 52, multiplier 53, on-timer 54, current zero-crossing detection module 55, and RS flip-flop 56, the controller further includes harmonic ratio adjustment module 61, harmonic component generation module 62, multipliers 63-1 to 63-n, an adder 64, a multiplier 65, a divider 66, an adder 67, and a multiplier 68. In such case, subtractor 51 acquires the difference between output voltage sampling signal SVout and voltage reference signal Vref and then outputs the difference to voltage compensation module 52. Further, the voltage compensation module 52 outputs compensation signal Vcmp. Further, harmonic component generation module 62 generates each predetermined harmonic component based on input voltage sampling signal SVin, such as third harmonic SH3, fifth harmonic SH5 and the like. Harmonic ratio adjustment module 61 outputs the amplitude ratio of each predetermined harmonic component based on the measured total harmonic distortion THD, and adjusts the amplitude ratio to decrease the THD. Amplitude ratios outputted from harmonic ratio adjustment module 61 are multiplied by corresponding predetermined harmonic components in multipliers 63-1 to 63-n respectively to generate at least one voltage harmonic component. All voltage harmonic components are superimposed in adder 64 to obtain an output parameter SVin', which satisfies the following formula:

$$SVin' = SH3*Ratio3+SH5*Ratio5+....$$

In the formula above, Ratioi represents an amplitude ratio of an i-th predetermined harmonic component which is generated and adjusted by harmonic ratio adjustment module 61. Input signal SVin' is multiplied by amplitude Vm of the fundamental component in the multiplier 65. The product is divided by input voltage sampling signal SVin in divider 66. The quotient is added to 1 to generate an added signal in adder 67. The added signal is the control signal for controlling the on-time. Then, the control signal is multiplied by a product of compensation signal Vcamp times proportional coefficient K in multiplier 68. The multiplied control signal product characterizes new on-time $T_{on-new1}$. On-timer 54 times under control of the new on-time $T_{on-new1}$. RS flip-flop 56 is reset after turn-on timer 54 finishes timing.

$$T_{on-new1} = ((SVin' *Vm)/SVin+1)*K*Vcamp$$

$$= ((SVin+Vm*(SH3*Ratio3+SH5*Ratio5+\ldots ))/SVin)*K*Vcamp$$

Since the product of compensation signal Vcamp and K characterizes on-time Ton in the constant on-time mode, $T_{on-new1}$=Ton * (SVin + Vm * (SH3 * Ratio3 + SH5 * Ratio5 +...))/SVin. According to the setting above, the new on-time is equal to that of the new on-time in the above formulas. By adjusting the on-time, the predetermined harmonic component having the same amplitude ratio and opposite phase compared with the harmonic component in the input current of the switching-type regulator can be superimposed on the input current of the switching-type regulator. Therefore, the harmonic compensation is realized and the THD is decreased.

Harmonic ratio adjustment module 61 adjusts the amplitude ratio of each predetermined harmonic component according the method shown in FIG. 4 until the measured THD is no longer decreased. Here, by adjusting the on-time, the amplitude ratio of each inversely superimposed predetermined harmonic component on input current Iin of the switching-type regulator approaches to an actual amplitude ratio corresponding to the harmonic component in the input current. Thus, Harmonic components in the input current of the switching-type regulator effectively counteracted such that the total harmonic distortion THD is decreased.

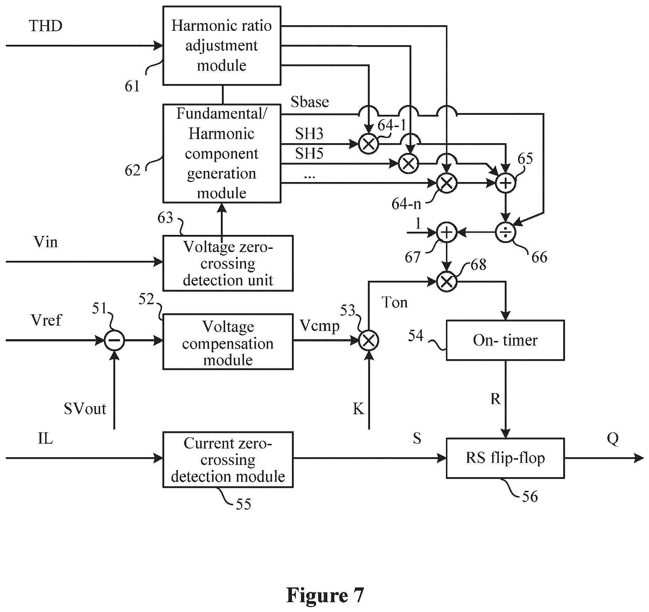

FIG. 7 is a diagram showing a data flow of the controller adjusting amplitude ratios of harmonic components according to a second comparative example of the present disclosure. In the second comparative example, the input voltage signal is not required to be sampled, and at least one predetermined harmonic component is inversely superimposed on the control signal for controlling the on-time of the main switch of the switching-type regulator, that is, the on-time is adjusted by using $T_{on-new2}$. As shown in FIG. 7, based on FIG. 5, on-time Ton in the constant on-time mode is further adjusted to decrease the THD. In addition to subtractor 51, voltage compensation module 52, multiplier 53, on-timer 54, current zero-crossing detection module 55, and RS flip-flop 56, the controller further includes harmonic ratio adjustment module 61, fundamental/harmonic component generation module 62, voltage zero-crossing detection unit 63, multipliers 64-1 to 64-n, adder 65, divider 66, adder 67, and multiplier 68. In such case, subtractor 51 acquires the difference between output voltage sampling signal SVout and voltage reference signal Vref and then outputs the difference to voltage compensation module 52. Further, voltage compensation module 52 outputs compensation signal Vcmp. At the same time, voltage zero-crossing detection unit 63 detects a zero-crossing signal of the input voltage and outputs the zero-crossing signal to fundamental/harmonic component generation module 62. The fundamental/harmonic component generation module 62 generates a fundamental component and the predetermined harmonic component, such as third harmonic SH3, and fifth harmonic SH5, based on the zero-crossing signal. Harmonic ratio adjustment module 61 outputs the amplitude ratio of each predetermined harmonic component based on the measured total harmonic distortion THD, and adjusts the amplitude ratio to decrease the THD. Amplitude ratios outputted from harmonic ratio adjustment module 61 are multiplied by corresponding predetermined harmonic components in multipliers 64-1 to 64-n respectively to generate at least one voltage harmonic component. All voltage harmonic components are superimposed in adder 65 to obtain an output parameter SVin', which satisfies the following formula:

$$SVin' = SH3*Ratio3+SH5*Ratio5+...$$

In the formula above, Ratioi represents an amplitude ratio of an i-th predetermined harmonic component which is generated and adjusted by harmonic ratio adjustment module 61. Input signal SVin' is divided by the fundamental component in divider 66. The quotient is added to 1 in adder 67 generating the control signal for controlling the on-time. The control signal is multiplied by a product of compensation signal Vcamp times proportionality coefficient K in multiplier 68. The multiplied control signal product characterizes new on-time $T_{on-new2}$ for controlling the turn-on timer 54 to time. RS flip-flop 56 is reset after on-timer 54 finishes timing.

$$T_{on-new2} = ((SH3*Ratio3+SH5*Ratio5+...)/Sbase+1)*K*Vcamp$$

$$= (Sbase+SH3*Ratio3+SH5*Ratio5+...)/SVin*K*Vcamp$$

Here, the product of the compensation signal Vcamp and K characterizes the on-time Ton in the constant on-time mode.

Thus, $T_{on-new2}$ = Ton* (Sbase+SH3 *Ratio3+SH5*Ratio5+...) /SVin. According to the setting above, the new on-time is equal to that of the new on-time in the above formulas. By adjusting the on-time, the predetermined harmonic component having the same amplitude ratio and opposite phase compared with the harmonic component in the input current of the switching-type regulator can be superimposed on the input current of the switching-type regulator. Therefore, the harmonic compensation is realized and the THD is decreased.

Harmonic ratio adjustment module 61 adjusts the amplitude ratio of each predetermined harmonic component according to the method shown in FIG. 4 until the measured THD is no longer decreased. By adjusting the on-time, the ratio of each predetermined harmonic component inversely superimposed on input current Iin of the switching-type regulator approaches an actual amplitude ratio corresponding to the harmonic component in the input current. Therefore, the the harmonic component in the input current can be harmonic component and the total harmonic distortion THD is decreased.

According to the first comparative example and the second comparative example of the present disclosure, the measured total harmonic distortion THD is used for feedback, such that the THD can be directly adjusted in a closed-loop manner. In such case, the THD can be reduced without performing compensation specifically for a category of factors affecting THD indicators, thereby simplifying the control method.

In the comparative example, the predetermined harmonic component is inversely superimposed on the control signal for controlling the on-time of the main switch. Specifically, the amplitude ratio of the predetermined harmonic component is adjusted to control the on-time of the on-time of the main switch such that the predetermined harmonic component is inversely superimposed on the input current. In that case, the compensation for the harmonic component in the input current. In addition, the compensation method is not limited to the mentioned above. It should be understood by those skilled in the art that the parameters and the module mentioned above can be modified to achieve the same goal. For example, in the first embodiment, signal SVin' after being obtained is multiplied by Vm in multiplier 65. Then the product is added to input voltage sampling signal SVin. Then the added signal is divided by SVin. In addition, the other process is the same as that of the first comparative example, so as to obtain new on-time $T_{on-new1}$. Similarly, in the second comparative example, when signal SVin' is obtained, signal SVin' is first added to fundamental component Sbase. The added signal is divided by the fundamental component Sbase. Here, the other process is the same as that of the second comparative example, so as to obtain new on-time $T_{on-new2}$. In addition, in the first and second comparative examples, if the voltage harmonic components generated by the harmonic generation module are not inverted, reference symbol 67 is subtractor to achieve the same function. It should be understood that any control method based on the mention formulas about $T_{on-new1}$ and $T_{on-new2}$ is within the protection scope of the present disclosure.

In the first and second comparative examples of the present disclosure, current zero-crossing detection module 55 is configured to perform zero-crossing detection on the inductor current. When the inductor current is detected crossing zero, RS flip-flop 56 is set outputting switch control signal Q. Off-time of the main switch of the switching-type regulator is controlled by zero-crossing detection, which is merely for corresponding to the conventional technology described in the present disclosure. Therefore, the present disclosure is not limited thereto. The other for controlling the off-time of the main switch can also be applied in the circuit.

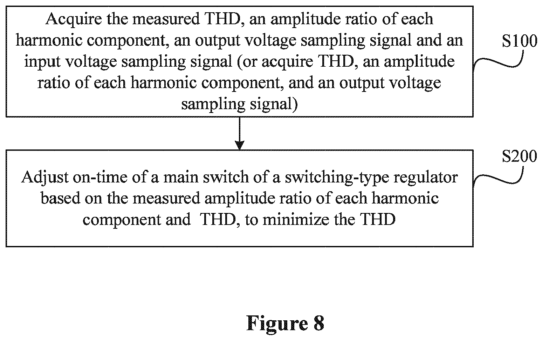

FIG. 8 is a flowchart of a control method according to the invention. A phase of each predetermined harmonic component is adjusted based on the measured THD and amplitude ratio Hn of the predetermined harmonic component to decrease the THD. As shown in FIG. 8, specifically, the control method includes the following steps S 100 to S200.

In step S100, the measured total harmonic distortion THD, amplitude ratio Hn of each harmonic component, input voltage sampling signal SVin and output voltage sampling signal SVout are acquired. Alternatively, the measured total harmonic distortion THD, an amplitude ratio Hn of each harmonic component, and output voltage sampling signal SVout are acquired.

In step S200, on-time of the main switch of the switching-type regulator is adjusted based on the measured amplitude ratio Hn of each harmonic component and THD, to decrease the total harmonic distortion THD.

Further, in step S200, power factor correction is also performed in other control loops based on input voltage sampling signal SVin and output voltage sampling signal SVout or based on output voltage sampling signal SVout.

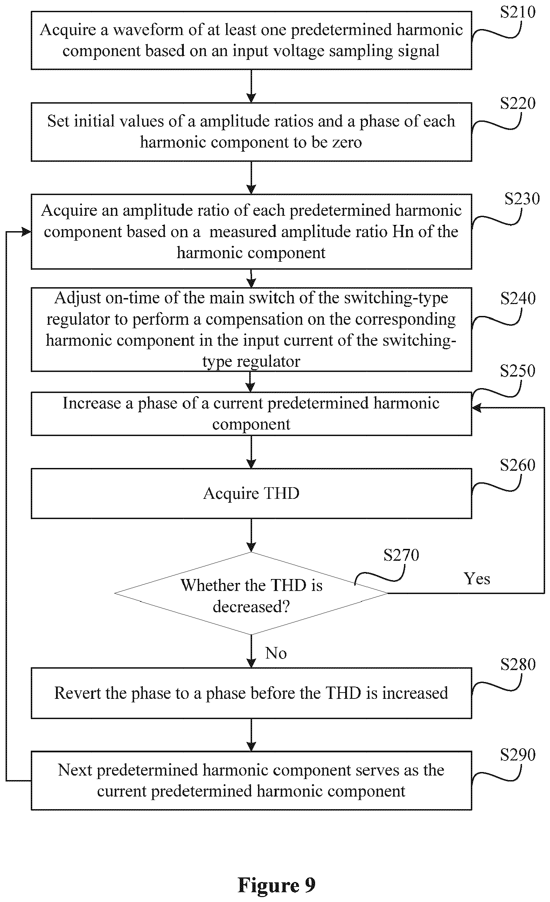

Specifically, in step S200, the total harmonic distortion THD is decreased by setting an amplitude ratio of each predetermined harmonic component and adjusting a phase of each predetermined harmonic component. FIG. 9 is a flowchart of a first method for adjusting a phase of a harmonic component according to the present invention. As shown in FIG 9, the phase of each predetermined harmonic component is adjusted in a phase increasing manner. The method includes the following steps.

In step S210, at least one predetermined harmonic component is acquired based on the input voltage sampling signal.

Since there may be multiple harmonic components in an input voltage, compensation is generally performed on only one or more harmonic components with a frequency close to a fundamental frequency. The at least one predetermined harmonic components are ranked in advance respectively, and an amplitude ratio of each predetermined harmonic component is set in order based on the measured amplitude ratio Hn of corresponding harmonic components, and a phase of each predetermined harmonic component is adjusted one-by-one.

In step S220, initial values of the amplitude ratio and the phase of each predetermined harmonic component are set to be zero.

In step S230, the amplitude ratio of each predetermined harmonic component is acquired based on the measured amplitude ratio Hn of corresponding harmonic components.

In step S240, the on-time is adjusted to perform a compensation on the input current of the switching-type regulator.

Specifically, a predetermined harmonic component is acquired. Then, the predetermined harmonic component is multiplied by an amplitude ratio corresponding to the predetermined harmonic component to obtain a multiplied signal, and the multiplied signal is inversely superimposed on the control signal of the on-time of the main switch of the switching-type regulator.

In step S250, the phase of the predetermined harmonic component is progressively increased. The phase of the predetermined harmonic component may be increased with a predetermined step length, or with changed increased amplitude, which is calculated for every operation.

In step S260, the THD is measured again after adjusting the on-time of the main switch.

In step S270, it is determined whether the THD is reduced after progressively increasing the phase of the predetermined harmonic component. In a case that the THD is reduced, the process proceeds to step S250, to progressively increase the phase of the predetermined harmonic component. In a case that the THD is not reduced, it is indicated that the phase of the predetermined harmonic component before performing the progressive increase operation is opposite to the phase of the harmonic component in the input signal. Then the process proceeds to step S280.

In step S280, the phase of the predetermined harmonic component is reverted to the phase before the THD is increased.

In addition, the predetermined harmonic component having the phase before the THD is increased is superimposed on the control signal to adjust the on-time according to the formulas for $T_{on-new1}$ or $T_{on-new2}$.

In step S290, a next predetermined harmonic component is in turn used as a current predetermined harmonic component, and the process returns to the step S230 to adjust the phase of the next predetermined harmonic component.

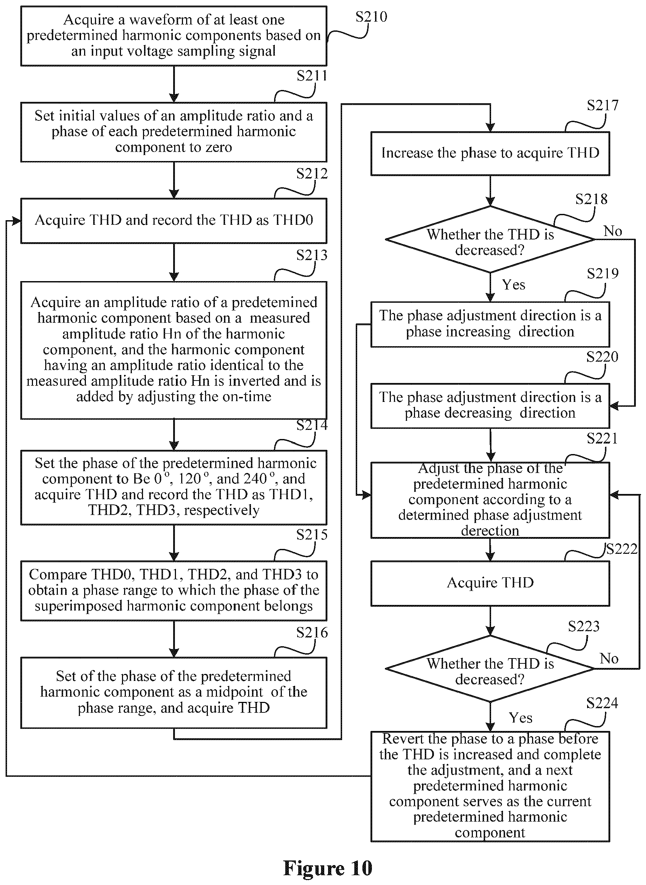

The method above for adjusting a phase in a progressive increase manner is performed easily. However, when the phase is large, it may be not easy to obtain the phase of the predetermined harmonic component to decrease the THD. FIG. 10 is a flowchart of a second method for adjusting a phase of a harmonic component according to the present invention. In this method, a phase of the predetermined harmonic component is adjusted in a phase partitioned manner which can easily obtain the phase of the predetermined harmonic component to decrease the THD. Specifically, the method includes the following steps 210 to S224.

In step S210, at least one predetermined harmonic component is acquired based on an input voltage sampling signal.

Since there may be multiple harmonic components in an input voltage, compensation is generally performed only on one or more harmonic components with a frequency close to a fundamental frequency. The at least one predetermined harmonic component are ranked in advance, and an amplitude ratio of each predetermined harmonic component is set in order based on the measured amplitude ratio Hn of corresponding harmonic components, and a phase of each predetermined harmonic component is adjusted one-by-one.

In step S211, initial values of the amplitude ratio and the phase of each predetermined harmonic component are set to be zero.

In step S212, a total harmonic distortion THD is acquired, which is represented by THD0.

In step S213, the amplitude ratio of each predetermined harmonic component is acquired based on the measured amplitude ratio Hn of corresponding harmonic components, and the predetermined harmonic component with the same amplitude ratio compared with the harmonic component in the input current of the switching-type regulator is inversely superimposed to the input current of switching-type regulator.

Specifically, a predetermined harmonic component is acquired. Then, the predetermined harmonic component is multiplied by an amplitude ratio corresponding to the predetermined harmonic component to obtain a multiplied signal, and the multiplied signal is inversely superimposed on the control signal of the on-time of the main switch of the switching-type regulator.

In step S214, the phase of the predetermined harmonic component is set to be 0°, 120° and 240° successively, and the total harmonic distortions THD are acquired, which are respectively represented by THD1, THD2 and THD3.

In step S215, magnitudes of the THD0, the THD1, the THD2 and the THD3 are compared with each other, and a phase range to which the phase of the predetermined harmonic component belongs is obtained.

Specifically, in a case that the THD1, the THD2 and the THD3 are greater than the THD0, it is indicated that it is unsuitable to perform compensation on a harmonic component of the input signal corresponding to the predetermined harmonic component (i.e., the input signal not includes the harmonic component corresponding to the predetermined harmonic component). Magnitudes of the THD1, the THD2 and the THD3 are compared with each other, and the phase range to which the phase of the predetermined harmonic component belongs is obtained.

It should be noted that there are various partition manners in step S214 and step S215. Moreover, only one embodiment is shown herein and the present disclosure is not limited thereto.

In step S216, the phase of the superimposed predetermined harmonic component is set as a midpoint of a phase range and the total harmonic distortion THD is acquired again.

In step S217, the phase is increased and the total harmonic distortion THD is acquired.

In step S218, it is determined whether the total harmonic distortion THD is reduced after increasing the phase. In a case that the THD is reduced, it is indicated that a phase adjustment direction is a phase-increasing direction and the process proceeds to step S219. In a case that the THD is not reduced, it is indicated that a phase adjustment direction is a phase-decreasing direction and the process proceeds to step S220.

In step S219, the phase adjustment direction is the phase-increasing direction.

In step S220, the phase adjustment direction is the phase-decreasing direction.

In step S221, the phase of the predetermined harmonic component is adjusted continually based on the determined phase adjustment direction.

Specifically, in a case that the phase adjustment direction is the phase-increasing direction, the current phase is progressively increased. In a case that the phase adjustment direction is the phase-decreasing direction, the current phase is progressively decreased.

In step S222, the THD is acquired.

In step S223, it is determined whether the total harmonic distortion THD is reduced. In a case that the total harmonic distortion THD is reduced, the process proceeds to step S221, to adjust the phase of the predetermined harmonic component continually according to the determined phase adjustment direction. In a case that the total harmonic distortion THD is not reduced, it is indicated that the phase of the predetermined harmonic component before the progressive increase operation is opposite to the phase of the corresponding harmonic component in the input signal, therefore the process proceeds to step S224.

In step S224, in step S224, the phase is reverted to a phase before the THD is not increased, and the phase adjustment is completed. Moreover, the predetermined harmonic component having the phase before the total harmonic distortion is not increased is inversely superimposed on the input current of the switching-type regulator. A next harmonic component is in turn used as a current predetermined harmonic component, and the process returns to the step S212 to adjust the phase of the next predetermined harmonic component.

As described above, for the predetermined harmonic components, an amplitude ratio of each predetermined harmonic component is set based on the measured amplitude ratio Hn of corresponding harmonic components and the phase of each predetermined harmonic component is adjusted in an one-by-one manner, such that the phase of the predetermined harmonic component is opposite to the phase of a corresponding harmonic component in the input signal, thereby minimizing a THD. It is to be noted that, the adjusting of the phase of each predetermined harmonic component is maintained during operation of a system, such that the THD of the system is reduced during the whole operation.

It is to be noted that manners of adjusting a phase of each predetermined harmonic component is not limited to the above two manners. For example, a phase for minimizing the THD may also be acquired by continually increasing the phase within a phase range after phase partition.

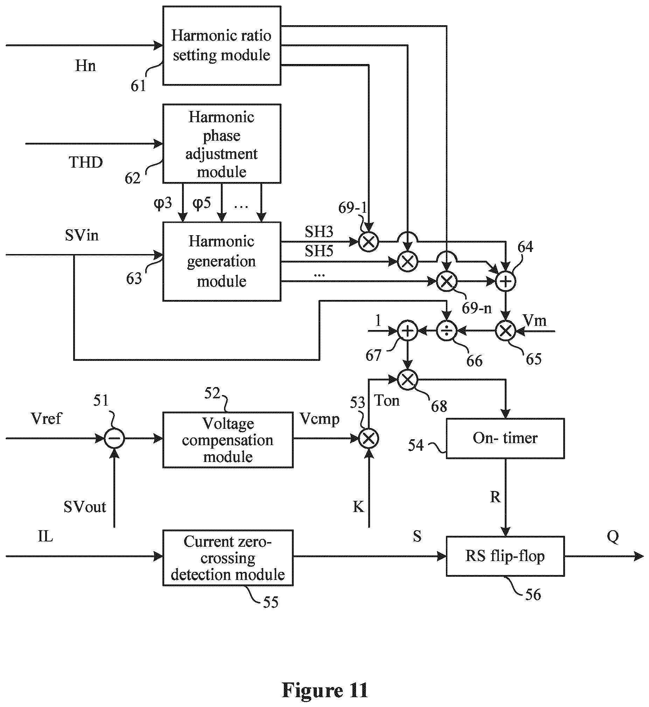

FIG. 11 is a schematic diagram showing a data flow of the controller adjusting phases of harmonic components according to a first embodiment according to the present invention. In the first embodiment, the input voltage signal is required to be sampled, at least one predetermined harmonic component is inversely superimposed on the control signal for controlling the on-time of the main switch of the switching-type regulator. That is, the on-time is adjusted by $T_{on-new1}$. As shown in FIG. 11, based on the control method in FIG. 5, the on-time Ton in the constant on-time mode is further adjusted to decrease the THD. In addition to subtractor 51, voltage compensation module 52, multiplier 53, on-timer 54, current zero-crossing detection module 55, and RS flip-flop 56, the controller further includes harmonic ratio setting module 61, harmonic phase adjustment module 62, harmonic component generation module 63, multipliers 69-1 to 69-n, adder 64, multiplier 65, divider 66, adder 67, and multiplier 68. In such case, subtractor 51 acquires the difference between output voltage sampling signal SVout and voltage reference signal Vref and then outputs the difference to voltage compensation module 52. Further, the voltage compensation module 52 outputs compensation signal Vcmp. Further, harmonic component generation module 63 generates each predetermined harmonic component based on input voltage sampling signal SVin, such as third harmonic SH3, fifth harmonic SH5 and the like. Harmonic ratio setting module 61 sets the amplitude ratio of each predetermined harmonic component based on the measured amplitude ratio Hn corresponding to the harmonic component. Harmonic phase adjustment module 62 outputs the phase of each predetermined harmonic component based on the measured total harmonic distortion THD, and adjusts the phase to decrease the THD. Amplitude ratios outputted from harmonic ratio setting module 61 are multiplied by corresponding predetermined harmonic components in multipliers 69-1 to 69-n respectively to generate at least one voltage harmonic component. All voltage harmonic components are superimposed in adder 64 to obtain an output parameter SVin', which satisfies the following formula:

$$SVin' = SH3*Ratio3 + SH5*Ratio5 + ...$$

In the formula above, Shi represents an i-th predetermined harmonic component having a phase. Specifically, $Shi = \sin(i*wt + \varphi_i)$, and $\varphi_i$ represents the phase of the i-th predetermined harmonic component. Ratioi represents an amplitude ratio of an i-th predetermined harmonic component which is generated and adjusted by harmonic ratio setting module 61.

Input signal SVin' is multiplied by amplitude Vm of the fundamental component in the multiplier 65. The product is divided by input voltage sampling signal SVin in divider 66. The quotient is added to 1 to generate an added signal in adder 67. The added signal is the control signal for controlling the on-time. Then, the control signal is multiplied by a product of compensation signal Vcamp times proportional coefficient K in multiplier 68. The multiplied control signal product characterizes new on-time $T_{on\text{-}new1}$. On-timer 54 times under control of the new on-time $T_{on\text{-}new1}$. RS flip-flop 56 is reset after turn-on timer 54 finishes timing.

$$T_{on\text{-}new1} = ((SVin' *Vm)/SVin+1)*K*Vcamp$$

$$= ((SVin+Vm*(SH3*Ratio3+SH5*Ratio5+...))/SVin)*K*Vcamp$$

Since the product of compensation signal Vcamp and K characterizes on-time Ton in the constant on-time mode, $T_{on\text{-}new1}=Ton * (SVin + Vm * (SH3 * Ratio3 + SH5 * Ratio5 +...))/SVin$. According to the setting above, the new on-time is equal to that of the new on-time in the above formulas. By adjusting the on-time, the predetermined harmonic component having the same amplitude ratio and opposite phase compared with the harmonic component in the input current of the switching-type regulator can be superimposed on the input current of the switching-type regulator. Therefore, the harmonic compensation is realized and the THD is decreased.

Harmonic phase adjustment module 62 may adjust the phase of each predetermined harmonic component according the method shown in FIG. 9 or FIG. 10 until the measured THD is no longer decreased. By adjusting the on-time, the phase of each predetermined harmonic component inversely superimposed on input current Iin of the switching-type regulator is adjusted to be opposite to that of an actual harmonic component in the input current. Thus, harmonic components in the input current of the switching-type regulator effectively counteracted such that the total harmonic distortion THD is decreased.

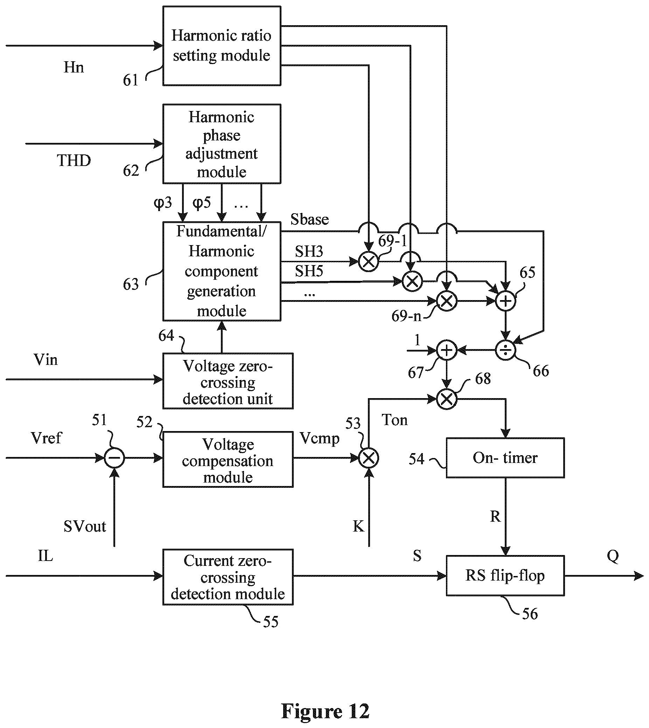

FIG. 12 is a diagram showing a data flow of the controller adjusting phases of harmonic components according to a second embodiment according to the present invention. In the second embodiment, the input voltage signal is not required to be sampled, and at least one predetermined harmonic component is inversely superimposed on the control signal for controlling the on-time of the main switch of the switching-type regulator, that is, the on-time is adjusted by using $T_{on\text{-}new2}$. As shown in FIG. 12, based on the control method shown in FIG. 5, on-time Ton in the constant on-time mode is further adjusted to decrease the THD. In addition to subtractor 51, voltage compensation module 52, multiplier 53, on-timer 54, current zero-crossing detection module 55, and RS flip-flop 56, the controller further includes harmonic ratio setting module 61, harmonic phase adjustment module 62, fundamental/harmonic component generation module 63, voltage zero-crossing detection unit 64, multipliers 69-1 to 69-n, adder 65, divider 66, adder 67, and multiplier 68. In such case, subtractor 51 acquires the difference between output voltage sampling signal SVout and voltage reference signal Vref and then outputs the difference to voltage compensation module 52. Further, voltage compensation module 52 outputs compensation signal Vcmp. At the same time, voltage zero-crossing detection unit 64 detects a zero-crossing signal of the input voltage and outputs the zero-crossing signal to fundamental/harmonic component generation module 63. The fundamental/harmonic component generation module 63 generates a fundamental component and the predetermined harmonic component, such as third harmonic SH3, and fifth harmonic SH5, based on the zero-crossing signal. Harmonic ratio setting module 61 sets the amplitude ratio of each predetermined harmonic component based on the measured amplitude ratio corresponding to the harmonic component in the input current. Harmonic phase adjustment module 62 outputs the phase of the predetermined harmonic component and adjusts the phase to decrease the THD. Amplitude ratios outputted from harmonic ratio setting module 61 are multiplied by corresponding predetermined harmonic components in multipliers 69-1 to 69-n respectively to generate at least one voltage harmonic component. All voltage harmonic components are superimposed in adder 65 to obtain an output parameter SVin', which satisfies the following formula.

$$SVin'=SH3*Ratio3+SH5*Ratio5+...$$

In the formula above, Shi represents an i-th predetermined harmonic component having a phase. Specifically, $Shi = \sin(i*wt + \varphi_i)$, and $\varphi_i$ represents the phase of the i-th predetermined harmonic component. Ratioi represents an amplitude ratio of an i-th predetermined harmonic component which is generated and adjusted by harmonic ratio setting module 61. Input signal SVin' is divided by the fundamental component in divider 66. The quotient is added to 1 in adder 67 generating the control signal for controlling the on-time. The control signal is multiplied by a product of compensation signal Vcamp times proportionality coefficient K in multiplier 68. The multiplied control signal product characterizes new on-time $T_{on-new2}$ for controlling the turn-on timer 54 to time. RS flip-flop 56 is reset after on-timer 54 finishes timing.

$$T_{on-new2} = ((SH3*Ratio3+SH5*Ratio5+... )/Sbase+1)*K*Vcamp$$

$$=(Sbase+SH3*Ratio3+SH5*Ratio5+... )/SVin*K*Vcamp$$

Here, the product of the compensation signal Vcamp and K characterizes the on-time Ton in the constant on-time mode

Thus, $T_{on-new2}$ = Ton* (Sbase+SH3*Ratio3+SH5*Ratio5+...) /SVin. According to the setting above, the new on-time is equal to that of the new on-time in the above formulas. By adjusting the on-time, the harmonic component having the same amplitude ratio and opposite phase compared with the harmonic component in the input current of the switching-type regulator can be inversely superimposed on the input current of the switching-type regulator. Therefore, the harmonic compensation is realized and the THD is decreased.

Harmonic phase adjustment module 62 may adjust the phase of each predetermined harmonic component according the method shown in FIG. 9 or FIG. 10 until the measured THD is no longer decreased. By adjusting the on-time, the phase of each predetermined harmonic component inversely superimposed on input current Iin of the switching-type regulator is adjusted to be opposite to that of an actual harmonic component in the input current. Thus, harmonic components in the input current of the switching-type regulator effectively counteracted such that the total harmonic distortion THD is decreased.

According to the first embodiment and the second embodiment of the present invention, the measured total harmonic distortion THD is used for feedback, such that the THD can be directly adjusted in a closed-loop manner. In such case, the THD can be reduced without performing compensation specifically for a category of factors affecting THD indicators, thereby simplifying the control method.

According to the first embodiment and the second embodiment of the present invention, the measured total harmonic distortion THD is used for feedback, such that the THD can be directly adjusted in a closed-loop manner. In such case, the THD can be reduced without performing compensation specifically for a category of factors affecting THD indicators, thereby simplifying the control method.

In the embodiment, the predetermined harmonic component is inversely superimposed on the control signal for controlling the on-time of the main switch. Specifically, the amplitude ratio of the predetermined harmonic component is adjusted to control the on-time of the on-time of the main switch such that the predetermined harmonic component is inversely superimposed on the input current. In that case, the compensation for the harmonic component in the input current. In addition, the compensation method is not limited to the mentioned above. It should be understood by those skilled in the art that the parameters and the module mentioned above can be modified to achieve the same goal. For example, in the first embodiment, signal SVin' after being obtained is multiplied by Vm in multiplier 65. Then the product is added to input voltage sampling signal SVin. Then the added signal is divided by SVin. In addition, the other process is the same as that of the first embodiment, so as to obtain new on-time $T_{on-new1}$. Similarly, in the second embodiment, when signal SVin' is obtained, signal SVin' is first added to fundamental component Sbase. The added signal is divided by the fundamental component Sbase. Here, the other process is the same as that of the fourth embodiment, so as to obtain new on-time $T_{on-new2}$. In addition, in the first and second embodiments, if the voltage harmonic components generated by the harmonic generation module are not inverted, reference symbol 67 is subtractor to achieve the same function. It should be understood that any control method based on the mention formulas about $T_{on-new1}$ and $T_{on-new2}$ is within the protection scope of the present disclosure.

In the first and second embodiments of the present disclosure, current zero-crossing detection module 55 is configured to perform zero-crossing detection on the inductor current. When the inductor current is detected over zero, RS flip-flop 56 is set outputting switch control signal Q. Off-time of the main switch of the switching-type regulator is controlled by zero-crossing detection, which is merely for corresponding to the conventional technology described in the present disclosure. Therefore the present disclosure is not limited thereto. The other for controlled the off-time of the main switch can also be applied in the circuit.

It should further be understood that the above methods, processes, units, and modules may be implemented by physical circuits or devices, or may be embodied as codes and/or data. The codes and/or data may be stored in a readable storage medium. When a processor reads and executes the above codes and/or data, the processor executes methods and processes that are embodied as data structures and codes and stored in the readable storage medium.

The controller described in the present disclosure may be implemented in various manners. For example, these technologies may be implemented in hardware, firmware, software, or a combination thereof. For hardware implementation, a processing unit for rate control at a receiving station may be implemented in one or more application specific integrated circuits (ASIC), digital signal processors (DSP), digital signal processing devices (DSPD), programmable logic devices (PLD), field programmable gate arrays (FPGA), processors, controllers, microcontrollers, microprocessors, other electronic units for performing the functions described in the present disclosure, or a combination thereof.

For firmware or software implementation, rate control may be implemented by modules (for example, processes or functions) that perform the functions described in the present disclosure. These software codes may be stored in a memory and executed by a processor. The memory may be implemented inside or outside the processor. In a case that the memory is implemented outside the processor, the memory is communicatively connected to the processor via various means, which are well known in the art.

The embodiments of the present disclosure are described below in conjunction with diagrams of operation waveform.

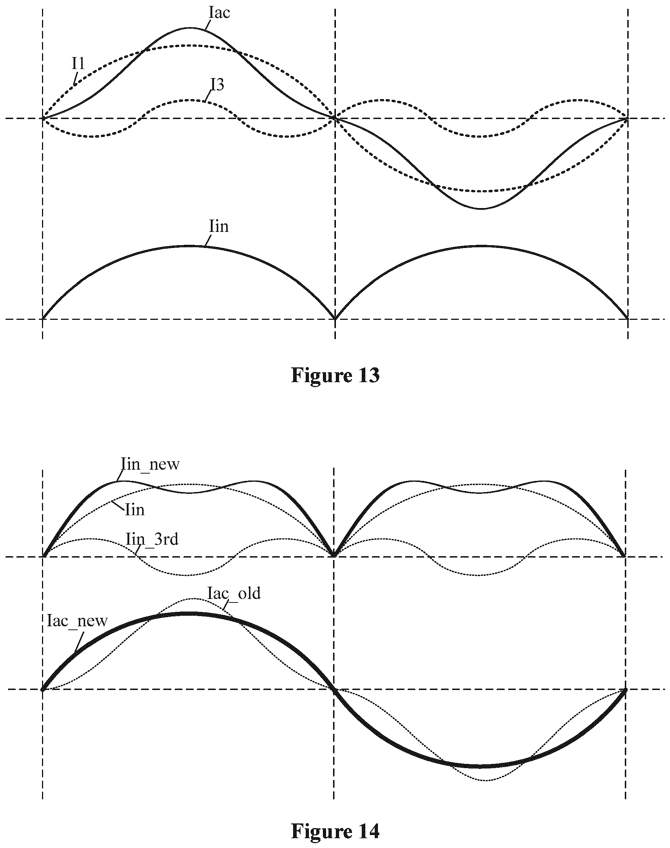

FIG. 13 is an operation waveform diagram of an example power factor correction circuit according to the present disclosure and FIG. 14 is an operation waveform diagram of another example power factor correction circuit according to the present disclosure. As shown in FIG. 13, it is assumed that the THD of input alternating current Iac is 25%, and the harmonic components are all third harmonic components. In FIG. 13, Iac represents a waveform of the input current of the power factor correction circuit, I1 represents a waveform of a fundamental current, and I3 represents a waveform of the third harmonic component, which follow a relationship of Iac = I1 + I3. When the system starts to operate, a sine wave having a phase and a waveform that are identical to that of input voltage Vin of switching-type regulator 22 is used. In the constant on-time mode, under the premise that input current Iin of the switching-type regulator is as shown in FIG. 13, the total harmonic distortion measured by power meter 1 is equal to 25%. Controller 3 may acquire a waveform of a third voltage harmonic (that is, a sinusoidal signal with a frequency of 3 multiples of the frequency of the fundamental signal) based on the waveform of the input voltage sampling signal SVin or by performing zero-crossing detection on input voltage Vin. Controller 3 adjusts an amplitude ratio or a phase of the third harmonic component based on the feedback total harmonic distortion THD. A third harmonic component is inverted and superimposed on the control signal for controlling the on-time of the main switch of the switching-type regulator, to adjust the on-time, so as to invert and superimpose a third harmonic component Iin_3rd on the input current based on the setting until the amplitude ratio or phase decreases the THD. Input current Iin_new after superposition is as shown in the FIG. 14. A comparison between input current Iac_new acquired after the third harmonic is compensated and input current Iac_old before adjustment is as shown in FIG. 14. It can be seen that the third harmonic in the input current is counteracted to the greatest extent. In a case that the predetermined harmonic components further include a fifth harmonic, a seventh harmonic and the like, the adjustment may be repeated to decrease the total harmonic distortion.

## Claims

1.  A power factor correction circuit, comprising:

    a power meter (1) configured to measure a total harmonic distortion (THD) at an input port;
    a switching-type regulator (22) that is controllable by a switch control signal in order to adjust a power factor;
    a controller (3) configured to generate the switch control signal to control the switching-type regulator (22) to perform power factor correction by controlling the on-time of the main switch of the switching-type regulator in a closed-loop control manner, wherein the main switch is turned on when it is detected that the inductor current crosses zero;

wherein the controller (3) is configured to inversely superimpose at least one predetermined harmonic component on a control signal for controlling an on-time of a main switch of the switching-type regulator (22) to adjust the on-time, to decrease the THD; wherein

the power meter (1) is further configured to measure an amplitude ratio (Hn) of each harmonic component at the input port, and

the controller (3) is configured to set the amplitude ratio of each of the predetermined harmonic components based on a measured amplitude ratio of a corresponding harmonic component, and, in a predetermined order of the predetermined harmonic components and for each predetermined harmonic component, to adjust a phase of the predetermined harmonic component based on the measured THD until the measured THD is no longer decreased, wherein either

the phase of each of the predetermined harmonic components is adjusted to progressively increase from zero until the measured THD is no longer decreased, or

phase partition is performed, and a phase range where the phase of each of the predetermined harmonic components is located is determined, the phase of each of the predetermined harmonic components is adjusted within the phase range until the measured THD is no longer decreased.

2. The power factor correction circuit according to claim 1, wherein the controller is configured to determine a midpoint of the phase range where the phase of each of the harmonic components is located as a reference point, and to determine whether a phase adjustment direction is a phase increasing direction or a phase decreasing direction, and to adjust the phase of each of the predetermined harmonic components based on the determined phase adjustment direction from the reference point until the measured THD is no longer decreased.

3. The power factor correction circuit according to claim 1, wherein the controller (3) is configured to perform:

either a) sampling the input voltage of the switching-type regulator (22) to obtain the input voltage sampling signal (SVin), and adjusting the on-time of the main switch of the switching-type regulator (22) based on the control signal, wherein the control signal is a quotient of a first signal divided by the input voltage sampling signal (SVin), the first signal is a product signal of an amplitude of a fundamental component (Vm) and a sum (SVin') of at least one voltage harmonic component (SH3, SH5, ...) corresponding to the at least one predetermined harmonic component, each voltage harmonic component (SH3, SH5, ...) has the same amplitude ratio with a corresponding harmonic component in the input signal and has an opposite phase to the corresponding harmonic component, and the predetermined harmonic component is acquired based on the input voltage sampling signal (SVin);

or b) sampling the input voltage of the switching-type regulator (22) to obtain the input voltage sampling signal (SVin), and adjusting the on-time of the main switch of the switching-type regulator (22) based on the control signal, wherein the control signal is one plus a quotient of a second signal divided by the input voltage sampling signal (SVin), the second signal is a product signal of an amplitude of a fundamental component (Vm) and a sum (SVin') of at least one voltage harmonic component (SH3, SH5, ...) corresponding to the at least one predetermined harmonic component, each voltage harmonic component (SH3, SH5, ...) has the same amplitude ratio with a corresponding harmonic component in the input signal and has an opposite phase to the corresponding harmonic component, and the predetermined harmonic component is acquired based on the input voltage sampling signal.

4. The power factor correction circuit according to claim 1, wherein the controller (3) is configured to perform:

either a) adjusting the on-time of the main switch of the switching-type regulator (22) based on the control signal, wherein the control signal is a quotient of a third signal divided by a fundamental component (Sbase), the third signal is a sum of at least one voltage harmonic component (SH3, SH5, ...) corresponding to the at least one predetermined harmonic component, each voltage harmonic component (SH3, SH5, ...) has the same amplitude ratio with a corresponding harmonic component in the input signal and has an opposite phase to the corresponding harmonic component, and the predetermined harmonic component is acquired by performing voltage zero-crossing detection on an input voltage;

or b) adjusting the on-time of the main switch of the switching-type regulator (22) based on the control signal, wherein the control signal is one plus a quotient of a fourth signal divided by a fundamental component (Sbase), the fourth signal is a sum (SVin') of at least one voltage harmonic component (SH3, SH5, ...) corresponding to the at least one predetermined harmonic component, each voltage harmonic component (SH3, SH5, ...) has the same amplitude ratio with a corresponding harmonic component in the input signal and has an opposite phase to the corresponding harmonic component, and the predetermined harmonic component is acquired by performing voltage zero-crossing detection on the input voltage.

5. The power factor correction circuit according to claim 3 or 4, wherein the voltage harmonic component is obtained by acquiring a product signal of each predetermined harmonic component and the amplitude ratio corresponding to the predetermined harmonic component and then performing a phase adjustment on the product signal.

6. The power factor correction circuit according to claim 3 or 4, wherein the voltage harmonic component is a product signal of the predetermined harmonic component and the amplitude ratio corresponding to the predetermined harmonic component.

7. The power factor correction circuit according to claim 3 or 4, wherein the controller (3) is configured to use k times a product of the control signal and a compensation signal for characterizing the on-time of the main switch of the switching-type regulator (22), and the compensation signal is a difference between a voltage reference signal and an output voltage.

8. The power factor correction circuit according to claim 1, wherein each of the at least one predetermined harmonic component is adjacent to a fundamental component (Vm).

**Patentansprüche**

1. Leistungsfaktorkorrekturschaltung, umfassend:

   einen Leistungsmesser (1), der ausgebildet ist, eine Oberschwingungsgesamtverzerrung (THD) an einem Eingangsport zu messen;
   einen Schaltregler (22), der durch ein Schaltsteuersignal steuerbar ist, um einen Leistungsfaktor einstellen;
   eine Steuerung (3), die ausgebildet ist, das Schaltsteuersignal zu erzeugen, um den Schaltregler (22) zum Durchführen einer Leistungsfaktorkorrektur durch Steuerung der Einschaltzeit des Hauptschalters des Schaltreglers in einer geschlossenen Schleife zu steuern, wobei der Hauptschalter eingeschaltet ist, wenn erfasst ist, dass der Spulenstrom Null durchquert; wobei
   die Steuerung (3) ausgebildet ist, mindestens eine vorbestimmte Oberschwingungskomponente auf einem Steuersignal zum Steuern einer Einschaltzeit eines Hauptschalters des Schaltreglers (22) zum Einstellen der Einschaltzeit invers zu überlagern, um die THD zu verringern; wobei
   der Leistungsmesser (1) ferner ausgebildet ist, ein Amplitudenverhältnis (Hn) jeder Oberschwingungskomponente an dem Eingangsport zu messen, und
   wobei die Steuerung (3) ausgebildet ist, das Amplitudenverhältnis von jeder der vorbestimmten Oberschwingungskomponenten basierend auf einem gemessenen Amplitudenverhältnis einer entsprechenden Oberschwingungskomponente einzustellen, und in einer vorbestimmten Reihenfolge der vorbestimmten Oberschwingungskomponenten und für jede vorbestimmte Oberschwingungskomponente eine Phase der vorbestimmten Oberschwingungskomponente basierend auf der gemessenen THD einzustellen, bis die gemessene THD nicht mehr weiter verringert wird, wobei entweder
   die Phase jeder der vorbestimmten Oberschwingungskomponenten schrittweise von Null ansteigend angepasst wird, bis die gemessene THD nicht mehr weiter verringert wird, oder
   eine Phasenaufteilung durchgeführt wird, und ein Phasenbereich, in dem die Phase von jeder der vorbestimmten Oberschwingungskomponenten lokalisiert ist, bestimmt wird, wobei die Phase von jeder der vorbestimmten Oberschwingungskomponenten innerhalb des Phasenbereichs eingestellt wird, bis die gemessene THD nicht mehr weiter verringert wird.

2. Leistungsfaktorkorrekturschaltung nach Anspruch 1, wobei die Steuerung ausgebildet ist, einen Mittelpunkt des Phasenbereichs, in dem die Phase von jeder der Oberschwingungskomponenten lokalisiert ist, als Referenzpunkt zu bestimmen und zu bestimmen, ob eine Phasenanpassungsrichtung eine Phasenerhöhungsrichtung oder eine Phasenverringerungsrichtung ist, und die Phase jeder der vorbestimmten Oberschwingungskomponenten basierend auf der bestimmten Phasenanpassungsrichtung von dem Referenzpunkt aus einzustellen, bis die gemessene THD nicht mehr weiter verringert wird.

3. Leistungsfaktorkorrekturschaltung nach Anspruch 1, wobei die Steuerung (3) ausgebildet ist, Folgendes auszuführen:

entweder a) Abtasten der Eingangsspannung des Schaltreglers (22), um das Eingangsspannungsabtastsignal (SVIn) zu erhalten, und Einstellen der Einschaltzeit des Hauptschalters des Schaltreglers (22) basierend auf dem Steuersignal, wobei das Steuersignal ein Quotient eines ersten Signals dividiert durch das Eingangsspannungsabtastsignal (SVIn) ist, wobei das erste Signal ein Produktsignal einer Amplitude einer Grundkomponente (Vm) und einer Summe (SVin') von mindestens einer Spannungsoberschwingungskomponente (SH3, SH5, ...) ist, die der mindestens einen vorgegebenen Oberschwingungskomponente entspricht, wobei jede Spannungsoberschwingungskomponente (SH3, SH5, ...) das gleiche Amplitudenverhältnis mit einer entsprechenden Oberschwingungskomponente in dem Eingangssignal aufweist und eine entgegengesetzte Phase zu der entsprechenden Oberschwingungskomponente aufweist, und wobei die vorbestimmte Oberschwingungskomponente basierend auf dem Eingangsspannungsabtastsignal (SVin) erfasst wird;

oder b) Abtasten der Eingangsspannung des Schaltreglers (22), um das Eingangsspannungsabtastsignal (SVin) zu erhalten und Einstellen der Einschaltzeit des Hauptschalters des Schaltreglers (22) basierend auf dem Steuersignal, wobei das Steuersignal Eins plus einem Quotienten eines zweiten Signals dividiert durch das Eingangsspannungsabtastsignal (SVin) ist, wobei das zweite Signal ein Produktsignal einer Amplitude einer Grundkomponente (Vm) und einer Summe (SVin') von mindestens einer Spannungsoberschwingungskomponente (SH3, SH5, ...) ist, die der mindestens einen vorbestimmten Oberschwingungskomponente entspricht, wobei jede Spannungsoberschwingungskomponente (SH3, SH5, ...) das gleiche Amplitudenverhältnis mit einer entsprechenden Oberschwingungskomponente in dem Eingangssignal aufweist und eine entgegengesetzte Phase zu der entsprechenden Oberschwingungskomponente aufweist, und wobei die vorbestimmte Oberschwingungskomponente basierend auf dem Eingangsspannungsabtastsignal erfasst wird.

4. Leistungsfaktorkorrekturschaltung nach Anspruch 1, wobei die Steuerung (3) ausgebildet ist, Folgendes auszuführen:

entweder a) Einstellen der Einschaltzeit des Hauptschalters des Schaltreglers (22) basierend auf dem Steuersignal, wobei das Steuersignal ein Quotient eines dritten Signals dividiert durch eine Grundkomponente (Sbase) ist, wobei das dritte Signal eine Summe von mindestens einer Spannungsoberschwingungskomponente (SH3, SH5, ...) ist, die der mindestens einen vorbestimmten Oberschwingungskomponente entspricht, wobei jede Spannungsoberschwingungskomponente (SH3, SH5, ...) das gleiche Amplitudenverhältnis mit einer entsprechenden Oberschwingungskomponente in dem Eingangssignal aufweist und eine entgegengesetzte Phase zu der entsprechenden Oberschwingungskomponente aufweist, und wobei die vorbestimmte Oberschwingungskomponente durch Durchführen einer Spannungsnulldurchgangsdetektion an einer Eingangsspannung erfasst wird;

oder b) Einstellen der Einschaltzeit des Hauptschalters des Schaltreglers (22) basierend auf dem Steuersignal, wobei das Steuersignal Eins plus ein Quotient eines vierten Signals dividiert durch eine Grundkomponente (Sbase) ist, wobei das vierte Signal eine Summe (SVin') von mindestens einer Spannungsoberschwingungskomponente (SH3, SH5, ...) ist, die der mindestens einen vorbestimmten Oberschwingungskomponente entspricht, wobei jede Spannungsoberschwingungskomponente (SH3, SH5, ...) das gleiche Amplitudenverhältnis mit einer entsprechenden Oberschwingungskomponente in dem Eingangssignal aufweist und eine entgegengesetzte Phase zu der entsprechenden Oberschwingungskomponente aufweist, und wobei die vorbestimmte Oberschwingungskomponente durch Durchführen einer Spannungsnulldurchgangserfassung an der Eingangsspannung erfasst wird.

5. Leistungsfaktorkorrekturschaltung nach Anspruch 3 oder 4, wobei die Spannungsoberschwingungskomponente durch Erfassen eines Produktsignals von jeder vorbestimmten Oberschwingungskomponente und dem Amplitudenverhältnis, das der vorbestimmten Oberschwingungskomponente entspricht, und dann durch Durchführen einer Phaseneinstellung an dem Produktsignal erhalten wird.

6. Leistungsfaktorkorrekturschaltung nach Anspruch 3 oder 4, wobei die Spannungsoberschwingungskomponente ein Produktsignal der vorbestimmten Oberschwingungskomponente und dem Amplitudenverhältnis ist, das der vorbestimmten Oberschwingungskomponente entspricht.

7. Leistungsfaktorkorrekturschaltung nach Anspruch 3 oder 4, wobei die Steuerung (3) ausgebildet ist, das k-fache eines Produkts des Steuersignals und eines Kompensationssignals für eine Charakterisierung der Einschaltdauer des Hauptschalters des Schaltreglers (22) zu verwenden, und wobei das Kompensationssignal eine Differenz zwischen einem Spannungsreferenzsignal und einer Ausgangsspannung ist.

**8.** Leistungsfaktorkorrekturschaltung nach Anspruch 1, wobei jede der mindestens einen vorbestimmten Oberschwingungskomponenten benachbart zu einer Grundkomponente (Vm) ist.

**Revendications**

**1.** Circuit de correction de facteur de puissance, comprenant :

un capteur de puissance (1) configuré pour mesurer une distorsion harmonique totale (THD) à un port d'entrée,
un régulateur de type à commutation (22) qui est commandable par un signal de commande de commutateur afin d'ajuster un facteur de puissance ;
un dispositif de commande (3) configuré pour générer le signal de commande de commutateur pour commander le régulateur de type à commutation (22) afin de réaliser une correction de facteur de puissance par la commande du temps de marche du commutateur principal du régulateur de type à commutation d'une manière de commande en boucle fermée, dans lequel le commutateur principal est mis en marche lorsqu'il est détecté que le courant d'inducteur passe à zéro ;
dans lequel le dispositif de commande (3) est configuré pour superposer inversement au moins une composante harmonique prédéterminée sur un signal de commande permettant de commander un temps de marche d'un commutateur principal du régulateur de type à commutation (22) pour ajuster le temps de marche, pour diminuer la THD ; dans lequel
le capteur de puissance (1) est en outre configuré pour mesurer un rapport d'amplitude (Hn) de chaque composante harmonique au niveau du port d'entrée, et
le dispositif de commande (3) est configuré pour régler le rapport d'amplitude de chacune des composantes harmoniques prédéterminées sur la base d'un rapport d'amplitude mesuré d'une composante harmonique correspondante, et, dans un ordre prédéterminé des composantes harmoniques prédéterminées et pour chaque composante harmonique prédéterminée, pour ajuster une phase de la composante harmonique prédéterminée sur la base de la THD mesurée jusqu'à ce que la THD mesurée ne soit plus diminuée, dans lequel soit
la phase de chacune des composantes harmoniques prédéterminées est ajustée pour augmenter progressivement à partir de zéro jusqu'à ce que la THD mesurée ne soit plus diminuée, soit
une partition de phase est réalisée, et une plage de phase où la phase de chacune des composantes harmoniques prédéterminées est située est déterminée, la phase de chacune des composantes harmoniques prédéterminées est ajustée dans la plage de phase jusqu'à ce que la THD mesurée ne soit plus diminuée.

**2.** Circuit de correction de facteur de puissance selon la revendication 1, dans lequel le dispositif de commande est configuré pour déterminer un point médian de la plage de phase où la phase de chacune des composantes harmoniques est située comme point de référence, et pour déterminer si une direction d'ajustement de phase est une direction d'augmentation de phase ou une direction de diminution de phase, et pour ajuster la phase de chacune des composantes harmoniques prédéterminées sur la base de la direction d'ajustement de phase déterminée à partir du point de référence jusqu'à ce que la THD mesurée ne soit plus diminuée.

**3.** Circuit de correction de facteur de puissance selon la revendication 1, dans lequel le dispositif de commande (3) est configuré pour réaliser :

soit a) un échantillonnage de la tension d'entrée du régulateur de type à commutation (22) pour obtenir le signal d'échantillonnage de tension d'entrée (SVin), et un ajustement du temps de marche du commutateur principal du régulateur de type à commutation (22) sur la base du signal de commande, dans lequel le signal de commande est un quotient d'un premier signal divisé par le signal d'échantillonnage de tension d'entrée (SVin), le premier signal est un signal de produit d'une amplitude d'une composante fondamentale (Vm) et d'une somme (SVin') d'au moins une composante harmonique de tension (SH3, SH5,...) correspondant à l'au moins une composante harmonique prédéterminée, chaque composante harmonique de tension (SH3, SH5,...) a le même rapport d'amplitude avec une composante harmonique correspondante dans le signal d'entrée et a une phase opposée à la composante harmonique correspondante, et la composante harmonique prédéterminée est acquise sur la base du signal d'échantillonnage de tension d'entrée (SVin) ;
soit b) un échantillonnage de la tension d'entrée du régulateur de type à commutation (22) pour obtenir le signal d'échantillonnage de tension d'entrée (SVin), et un ajustement du temps de marche du commutateur principal du régulateur de type à commutation (22) sur la base du signal de commande, dans lequel le signal de commande est un plus un quotient d'un deuxième signal divisé par le signal d'échantillonnage de tension d'entrée (SVin), le deuxième signal est un signal de produit d'une amplitude d'une composante fondamentale (Vm) et d'une somme (SVin') d'au moins une composante harmonique de tension (SH3, SH5, ... ) correspondant à l'au moins une composante harmonique prédéterminée, chaque composante harmonique de tension (SH3, SH5, ...) a le même rapport d'amplitude avec une composante harmonique correspondante dans le signal d'entrée et a une phase opposée à la composante harmonique correspondante, et la composante harmonique prédéterminée est acquise sur la base du signal d'échantillonnage de tension d'entrée.

4. Circuit de correction de facteur de puissance selon la revendication 1, dans lequel le dispositif de commande (3) est configuré pour réaliser :

soit a) un ajustement du temps de marche du commutateur principal du régulateur de type à commutation (22) sur la base du signal de commande, dans lequel le signal de commande est un quotient d'un troisième signal divisé par une composante fondamentale (Sbase), le troisième signal est une somme d'au moins une composante harmonique de tension (SH3, SH5,...) correspondant à l'au moins une composante harmonique prédéterminée, chaque composante harmonique de tension (SH3, SH5,...) a le même rapport d'amplitude avec une composante harmonique correspondante dans le signal d'entrée et a une phase opposée à la composante harmonique correspondante, et la composante harmonique prédéterminée est acquise par la réalisation d'une détection de passage à zéro de tension sur une tension d'entrée ;
soit b) un ajustement du temps de marche du commutateur principal du régulateur de type à commutation (22) sur la base du signal de commande, dans lequel le signal de commande est un plus un quotient d'un quatrième signal divisé par une composante fondamentale (Sbase), le quatrième signal est une somme (SVin') d'au moins une composante harmonique de tension (SH3, SH5,...) correspondant à l'au moins une composante harmonique prédéterminée, chaque composante harmonique de tension (SH3, SH5, ...) a le même rapport d'amplitude avec une composante harmonique correspondante dans le signal d'entrée et a une phase opposée à la composante harmonique correspondante, et la composante harmonique prédéterminée est acquise par la réalisation d'une détection de passage à zéro de tension sur la tension d'entrée.

5. Circuit de correction de facteur de puissance selon la revendication 3 ou 4, dans lequel la composante harmonique de tension est obtenue par l'acquisition d'un signal de produit de chaque composante harmonique prédéterminée et du rapport d'amplitude correspondant à la composante harmonique prédéterminée et puis par la réalisation d'un ajustement de phase sur le signal de produit.

6. Circuit de correction de facteur de puissance selon la revendication 3 ou 4, dans lequel la composante harmonique de tension est un signal de produit de la composante harmonique prédéterminée et du rapport d'amplitude correspondant à la composante harmonique prédéterminée.

7. Circuit de correction de facteur de puissance selon la revendication 3 ou 4, dans lequel le dispositif de commande (3) est configuré pour utiliser k fois un produit du signal de commande et d'un signal de compensation permettant de caractériser le temps de marche du commutateur principal du régulateur de type à commutation (22), et le signal de compensation est une différence entre un signal de référence de tension et une tension de sortie.

8. Circuit de correction de facteur de puissance selon la revendication 1, dans lequel chacune de l'au moins une composante harmonique prédéterminée est adjacente à une composante fondamentale (Vm).

**Figure 1**

**Figure 2**

Acquire the measured THD, an input voltage sampling signal, and an output voltage sampling signal (or acquire the measured THD and an output voltage sampling signal)

S100

Adjust on-time of a main switch of a switching-type regulator based on the measured THD, to decrease the THD

S200

**Figure 3**

Acquire a waveform of at least one predetermined harmonic component based on an input voltage sampling signal — S210

Set a initial value of a amplitude ratio of each predetermined harmonic component to zero — S220

Progressively increase an amplitude ratio of a current predetermined harmonic component — S230

Adjust on-time to perform a compensation on an input current of a switching-type regulator — S240

Acquire THD — S250

Whether the THD is decreased? — S260

Yes

No

Revert the amplitude ratio to a amplitude ratio before the THD is increased — S270

Next predetermined harmonic component serves as the current predetermined harmonic component — S280

**Figure 4**

**Figure 5**

**Figure 6**

**Figure 7**

Acquire the measured THD, an amplitude ratio of each
harmonic component, an output voltage sampling signal and an
input voltage sampling signal (or acquire THD, an amplitude
ratio of each harmonic component, and an output voltage
sampling signal)

S100

Adjust on-time of a main switch of a switching-type regulator
based on the measured amplitude ratio of each harmonic
component and THD, to minimize the THD

S200

**Figure 8**

Acquire a waveform of at least one predetermined harmonic component based on an input voltage sampling signal — S210

Set initial values of a amplitude ratios and a phase of each harmonic component to be zero — S220

Acquire an amplitude ratio of each predetermined harmonic component based on a measured amplitude ratio Hn of the harmonic component — S230

Adjust on-time of the main switch of the switching-type regulator to perform a compensation on the corresponding harmonic component in the input current of the switching-type regulator — S240

Increase a phase of a current predetermined harmonic component — S250

Acquire THD — S260

Whether the THD is decreased? — S270    Yes

No

Revert the phase to a phase before the THD is increased — S280

Next predetermined harmonic component serves as the current predetermined harmonic component — S290

**Figure 9**

Acquire a waveform of at least one predetermined harmonic components based on an input voltage sampling signal — S210

Set initial values of an amplitude ratio and a phase of each predetermined harmonic component to zero — S211

Acquire THD and record the THD as THD0 — S212

Acquire an amplitude ratio of a predetemined harmonic component based on a measured amplitude ratio Hn of the harmonic component, and the harmonic component having an amplitude ratio identical to the measured amplitude ratio Hn is inverted and is added by adjusting the on-time — S213

Set the phase of the predetermined harmonic component to Be 0°, 120°, and 240°, and acquire THD and record the THD as THD1, THD2, THD3, respectively — S214

Compare THD0, THD1, THD2, and THD3 to obtain a phase range to which the phase of the superimposed harmonic component belongs — S215

Set of the phase of the predetermined harmonic component as a midpoint of the phase range, and acquire THD — S216

Increase the phase to acquire THD — S217

Whether the THD is decreased? — S218
No
Yes

The phase adjustment direction is a phase increasing direction — S219

The phase adjustment direction is a phase decreasing direction — S220

Adjust the phase of the predetermined harmonic component according to a determined phase adjustment derection — S221

Acquire THD — S222

Whether the THD is decreased? — S223
No
Yes

Revert the phase to a phase before the THD is increased and complete the adjustment, and a next predetermined harmonic component serves as the current predetermined harmonic component — S224

**Figure 10**

30

**Figure 11**

**Figure 12**

Figure 13

Figure 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2018269779 A1

### Non-patent literature cited in the description

- **CHIH-WEI CHANG et al.** High-PF and ultra-low-THD power factor correction controller by sinusoidal-wave synthesis and optimized THD control. *CIRCUITS AND SYSTEMS (ISCAS), 2013 IEEE INTERNATIONAL SYMPOSIUM ON, IEEE,* 19 May 2013, 917-920

- **LIN HENG-CI et al.** A digitally variable on-time controlled PFC flyback converter with primary-side regulation. *2018 7TH INTERNATIONAL SYMPOSIUM ON NEXT GENERATION ELECTRONICS (ISNE), IEEE,* 07 May 2018